# EUROPEAN PATENT APPLICATION

(11) **EP 2 130 847 A1**
(43) Date of publication of application: **09.12.2009**
(21) Application number: 08739752.7
(22) Date of filing: 27.03.2008
(51) Int. Cl.: C08G 61/12, H01L 51/42

(54) **ORGANIC PHOTOELECTRIC CONVERTER AND POLYMER USEFUL FOR PRODUCTION OF THE SAME**

(30) Priority: 29.03.2007 JP 2007087282
(71) Applicant: Sumitomo Chemical Company, Limited, Tokyo 104-8260 (JP)
(72) Inventor: UETANI, Yasunori, Tsukuba-shi Ibaraki 305-0045 (JP); OGUMA, Jun, Cambridge, Cambridgeschire CB3 OHH (GB); TERAI, Hiroki, Tsukuba-shi Ibaraki 305-0005 (JP); FUJIWARA, Jun, Ashiya-shi Hyogo 659-0055 (JP)
(74) Representative: Duckworth, Timothy John
(86) International application number: PCT/JP2008/056642
(87) International publication number: WO 2008/120809

(57) **Abstract**

The present invention provides an organic photoelectric converter and a polymer useful for the production of the same. The polymer comprises a repeating unit comprising a structure represented by the following formula (1a) and/or a structure represented by the following formula (1b), and a structure represented by the following formula (2), wherein the A ring represents a 6- or more membered monocyclic alicyclic hydrocarbon, and the alicyclic hydrocarbon may be substituted by an alkyl group having 1 to 20 carbon atoms, and wherein R¹, R², R³, R⁴, R⁵, and R⁶ each independently represent a hydrogen atom, an alkyl group having 1 to 20 carbon atoms, an alkoxy group having 1 to 20 carbon atoms, or an aryl group having 6 to 60 carbon atoms; x is 1 or 2; y is 0 or 1; z is 0, 1, or 2; when a plurality of R¹, R², R³, R⁴, R⁵ or R⁶ are present, they may be the same or different; some or all of the hydrogen atoms of the alkyl group and the alkoxy group each may be substituted partially or wholly by a fluorine atom; and the aryl group may have a substituent.

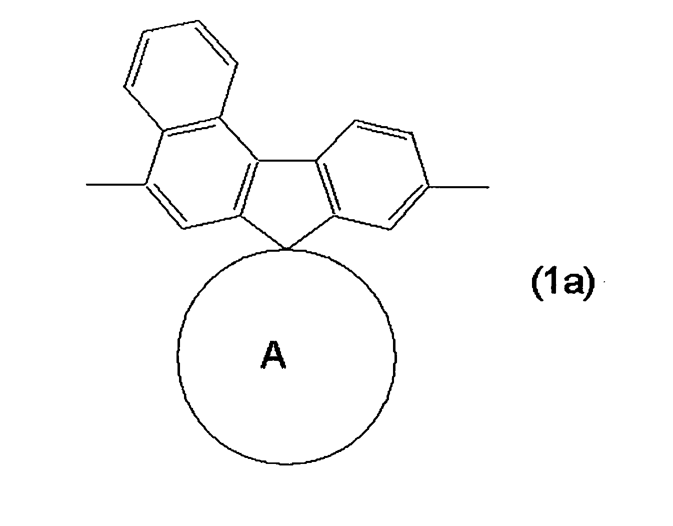

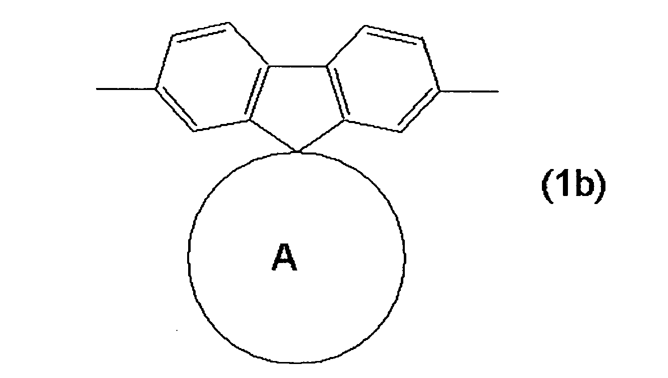

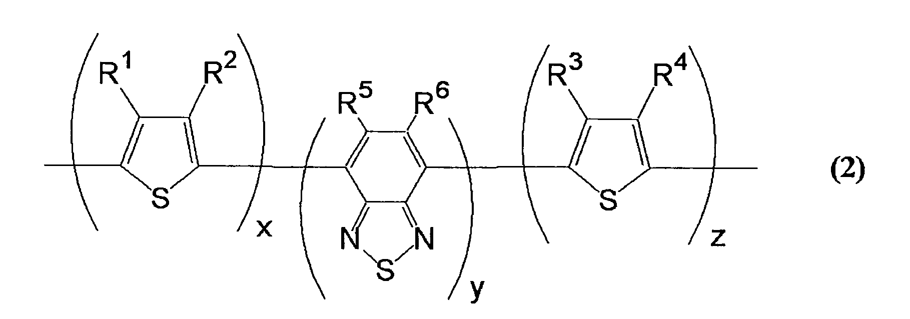

## Description

### Technical Field

The present invention relates to an organic photoelectric converter and a polymer useful for the production of the same.

### Background Art

Organic semiconductor materials having charge (electron or hole) transport properties have been expected to be applied to organic electroluminescent devices, organic transistors, and organic photoelectric converters (organic solar cells, photosensors, etc.) and have been studied in various ways.

The organic semiconductor materials are required to have high charge transport properties from the viewpoint of higher performance of organic photoelectric converters. From this viewpoint, aromatic compounds have been studied. Specifically, a polyfluorene copolymer comprising a fluorenediyl group and a thiophenediyl group has been proposed (Applied Physics Letters Vol. 84, No. 10 1653-1655 (2004)) as the organic semiconductor material.

However, the polyfluorene copolymer neither has sufficient charge transport properties nor gives sufficient photoelectric conversion efficiency even if used in the production of a photoelectric converter.

### Disclosure of the Invention

An object of the present invention is to provide a polymer which can impart excellent photoelectric conversion efficiency when used in the production of a photoelectric converter.

A first aspect of the present invention provides a polymer comprising a repeating unit comprising
a structure represented by the following formula (1a) and/or a structure represented by the following formula (1b), and
a structure represented by the following formula (2): 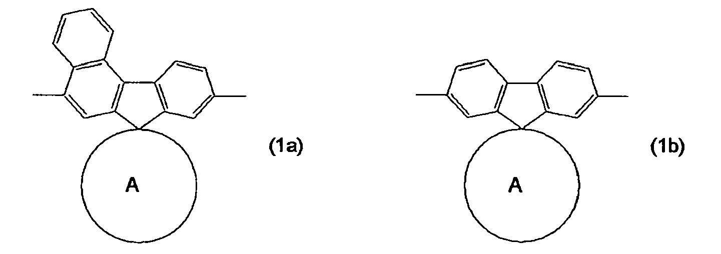 wherein the A ring represents a 6- or more membered monocyclic alicyclic hydrocarbon, and the alicyclic hydrocarbon may be substituted by an alkyl group having 1 to 20 carbon atoms, and 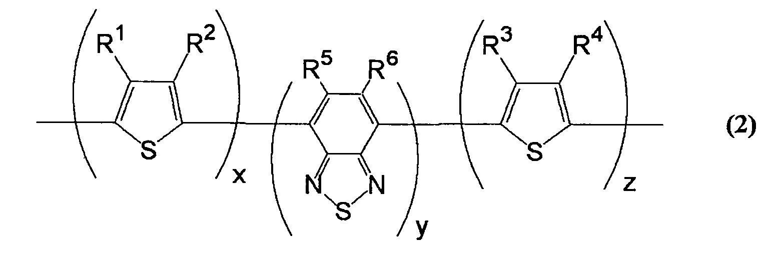 wherein R¹, R², R³, R⁴, R⁵, and R⁶ each independently represent a hydrogen atom, an alkyl group having 1 to 20 carbon atoms, an alkoxy group having 1 to 20 carbon atoms, or an aryl group having 6 to 60 carbon atoms; x is 1 or 2; y is 0 or 1; z is 0, 1, or 2; when a plurality of R¹, R², R³ R⁴, R⁵ or R⁶ are present, they may be the same or different; some or all of the hydrogen atoms of the alkyl group and the alkoxy group each may be substituted by a fluorine atom; and the aryl group may have a substituent.

A second aspect of the present invention provides an organic photoelectric converter comprising: a pair of electrodes; a first organic layer containing an electron-accepting compound, the first organic layer being disposed between the electrodes; and a second organic layer containing an electron-donating compound, the second organic layer being disposed adjacent to the first organic layer, wherein the electron-donating compound or the electron-accepting compound is the polymer.

A third aspect of the present invention provides an organic photoelectric converter comprising: a pair of electrodes; and at least one organic layer containing an electron-accepting compound and an electron-donating compound, the organic layer being disposed between the electrodes, wherein the electron-donating compound or the electron-accepting compound is the polymer.

A fourth aspect of the present invention provides an organic photoelectric converter comprising: a pair of electrodes; and at least one organic layer containing an electron-accepting compound and an electron-donating compound, the organic layer being disposed between the electrodes, wherein the electron-donating compound is the polymer, and the electron-accepting compound is a fullerene derivative.

### Best Modes for Carrying Out the Invention

### <Polymer>

A polymer of the present invention comprises a repeating unit comprising a structure represented by the formula (1a) and/or a structure represented by the formula (1b), and a structure represented by the formula (2). Owing to the structures, the polymer of the present invention can presumably have enhanced molecular planarity and further have improved intermolecular packing, resulting in higher intermolecular interaction.

### Structures represented by formulas (1a)/(1b)

In the formulas (1a) and (1b), the A ring represents a 6- or more membered monocyclic alicyclic hydrocarbon. When a plurality of the A rings are present in the repeating unit, they may be the same or different. This alicyclic hydrocarbon may be substituted by an alkyl group having 1 to 20 carbon atoms. In the present specification, the "monocyclic alicyclic hydrocarbon" means cyclic hydrocarbon other than condensed aromatic rings. Owing to the monocyclic alicyclic hydrocarbon used as the A ring, the polymer of the present invention presumably has enhanced intermolecular interaction through easily overlapping molecules, resulting in improved charge transport properties.

The A ring is preferably a 10- or more membered ring, more preferably 12- to 30-membered ring, particularly preferably 14- to 20-membered ring, from the viewpoint of the solubility of the obtained polymer in a solvent. Examples of the structure of the A ring include: saturated alicyclic hydrocarbons such as cyclohexane, cycloheptane, cyclooctane, cyclononane, cyclodecane, cycloundecane, cyclododecane, cyclotridecane, cyclotetradecane, cyclopentadecane, cyclohexadecane, cycloheptadecane, cyclooctadecane, and cyclononadecane; and unsaturated alicyclic hydrocarbons such as cyclohexene, cyclohexadiene, cycloheptene, cyclohexadecene, and cyclooctatriene. Hydrogen atoms in these saturated or unsaturated alicyclic hydrocarbons may be substituted partially or wholly by an alkyl group having 1 to 20 carbon atoms. The alkyl group is, for example, linear or branched.

The A ring contains preferably 7 or more carbon atoms, more preferably 8 to 30 carbon atoms, particularly preferably 10 to 20 carbon atoms, in terms of the total number of carbon atoms contained in the A ring for more highly improving the solubility of the obtained polymer in a solvent. In the present specification, the "total number of carbon atoms contained in the A ring" means the number of all carbon atoms contained in the A ring inclusive of substituents.

When the polymer of the present invention is used in the production of an organic photoelectric converter, a polymerizable active group remaining as an end group therein may reduce the characteristics (e.g., durability) of the obtained device. Therefore, it is preferred that the end group should be protected with a stable group.

Examples of the end group include a hydrogen atom, an alkyl group, an alkoxy group, a fluoroalkyl group, a fluoroalkoxy group, an aryl group, an arylamino group, and a heterocyclic group. An electron-donating group such as an arylamino group is preferable from the viewpoint of enhancing hole transport properties by the end group. It is also preferred that the end group should have a conjugated bond consecutive to the conjugated structure of the main chain. Examples thereof include those bonded to an aryl or heterocyclic group via a carbon-carbon bond.

The polymer of the present invention is usually a conjugated polymer compound. In this context, the conjugated polymer compound means a compound in which the main chains of the molecules constituting the compound are substantially conjugated.

Examples of the structure represented by the formula (1a) include those shown below. In the illustrations below, a number within a ring corresponding to the A ring represents the number of carbon atoms constituting the ring corresponding to the A ring. Specifically, when the number is n, the A ring means an n-membered ring free from unsaturated bonds. For example, when the number is 9, the A ring is a cyclononane ring.

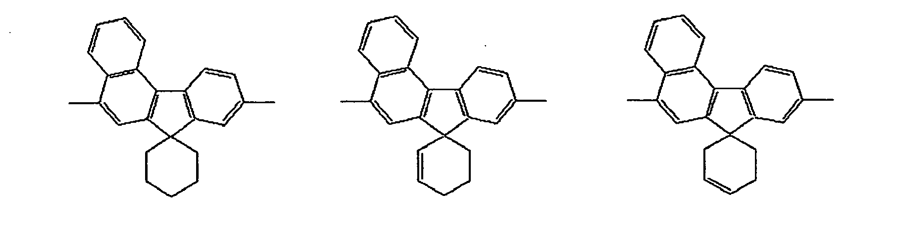

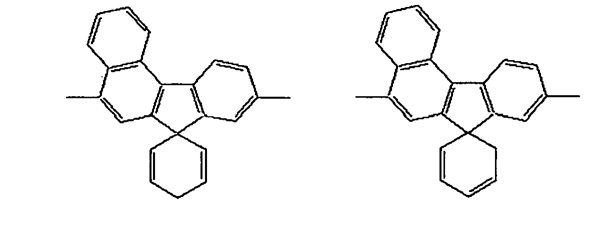

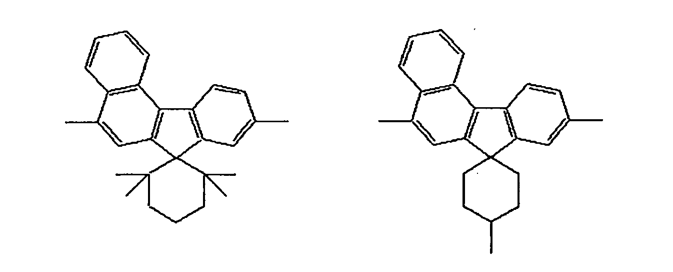

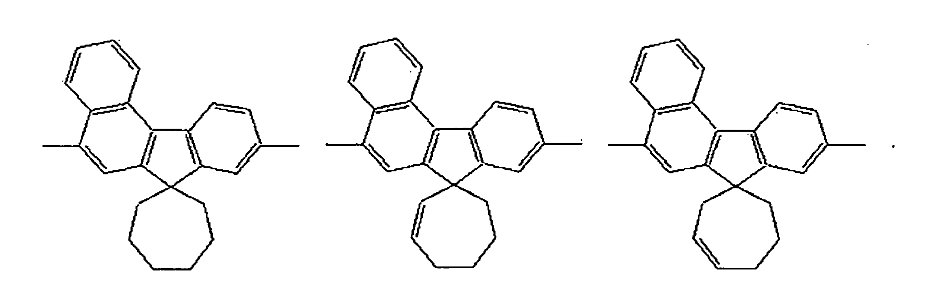

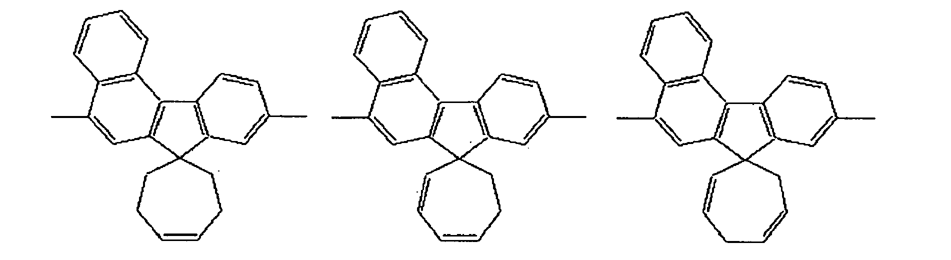

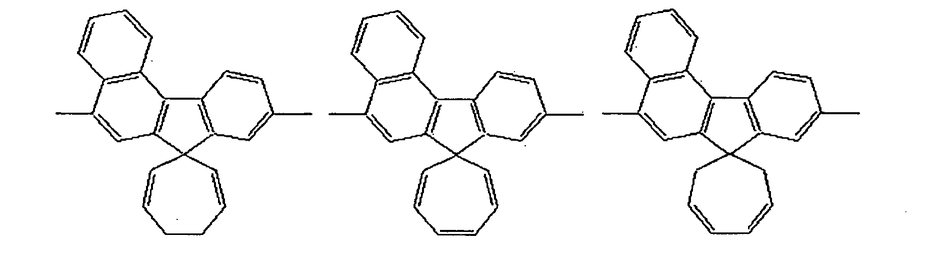

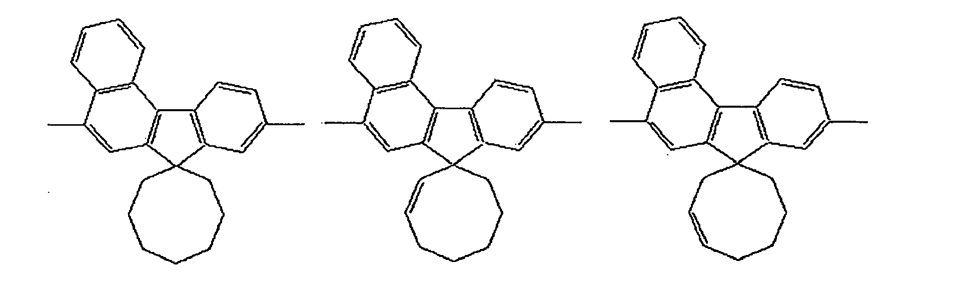

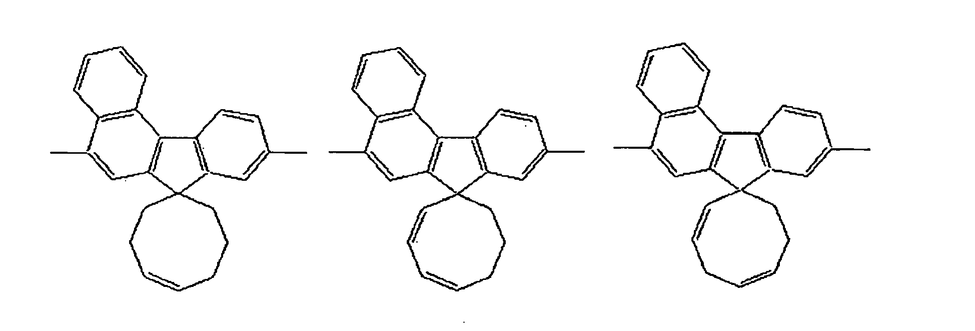

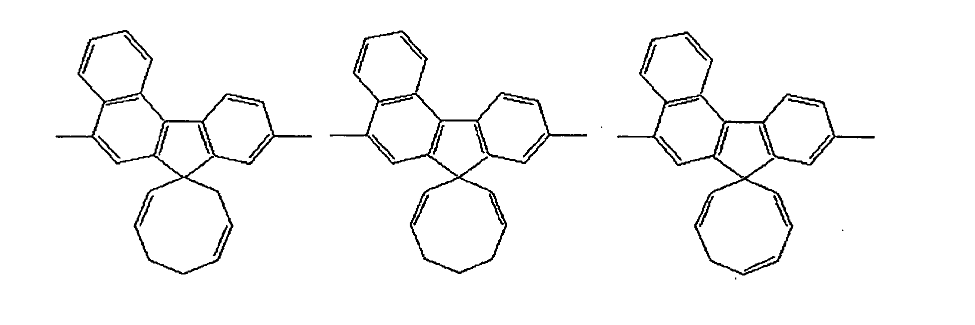

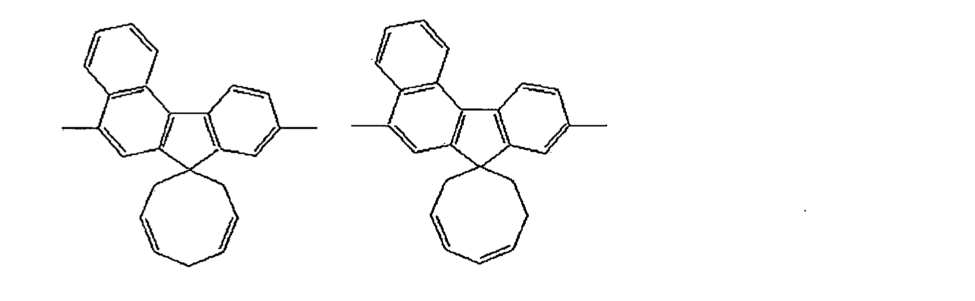

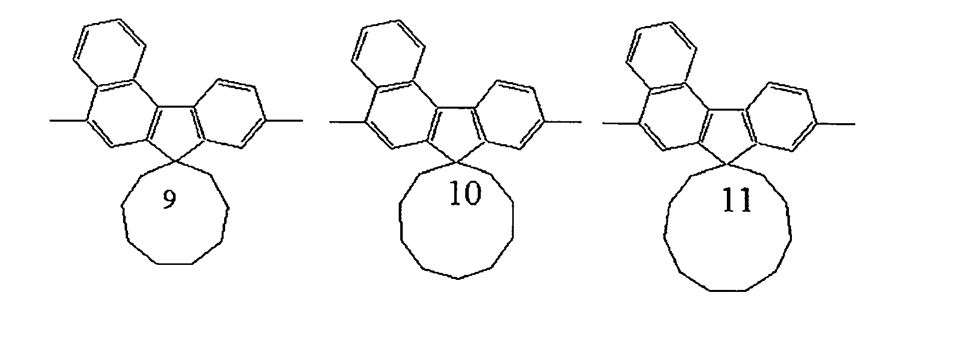

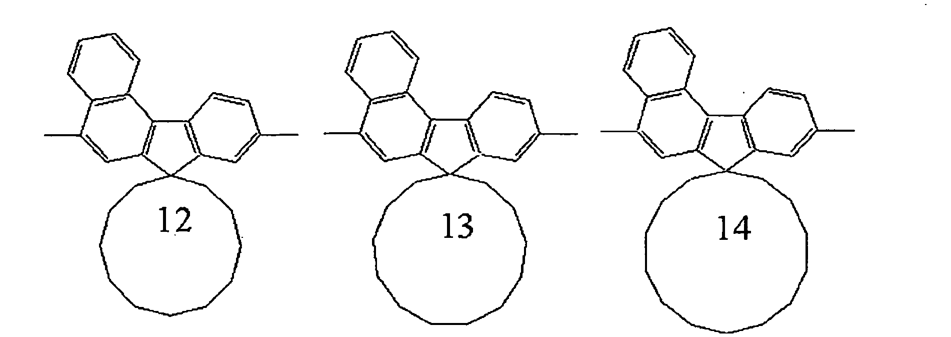

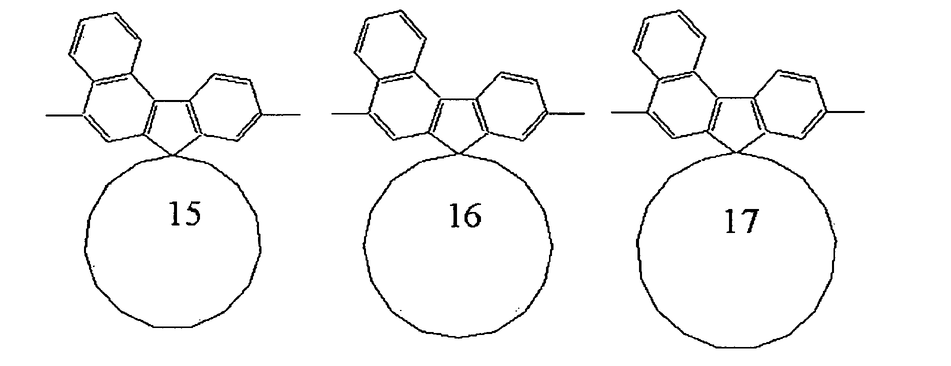

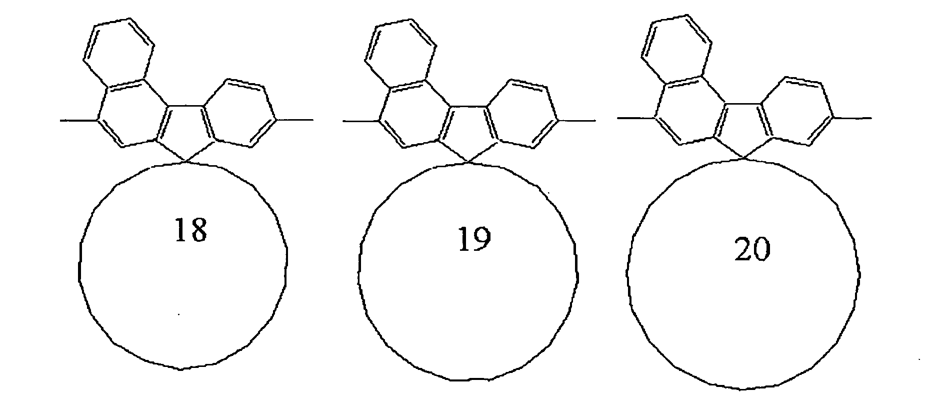

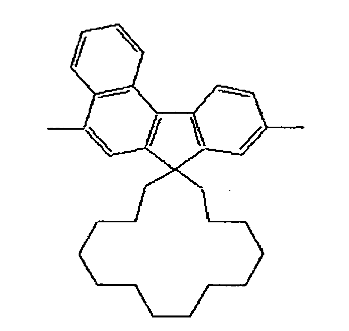

Among them, the following are preferable:

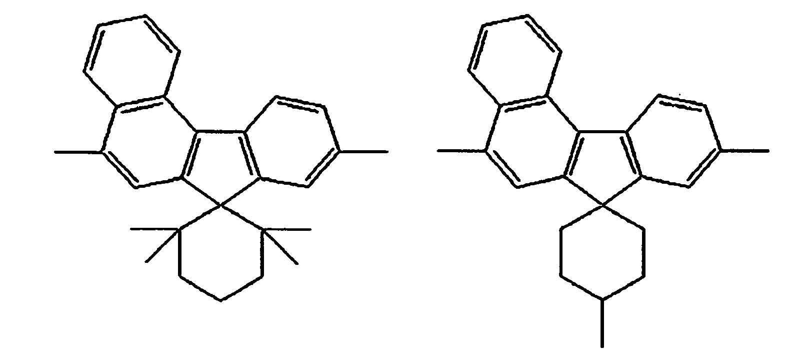

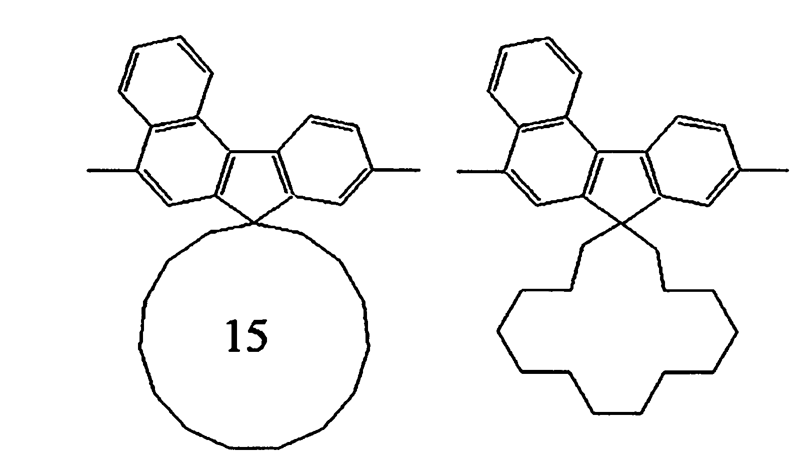

Examples of the structure represented by the formula (1b) include those shown below. In the illustrations below, a number within a ring corresponding to the A ring is as defined above.

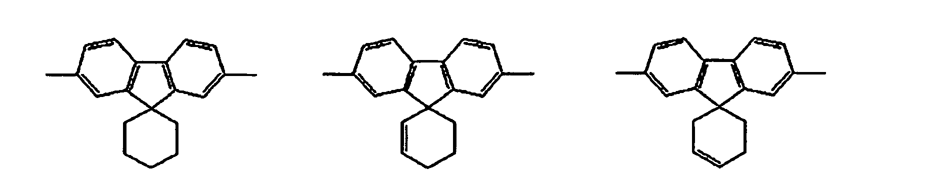

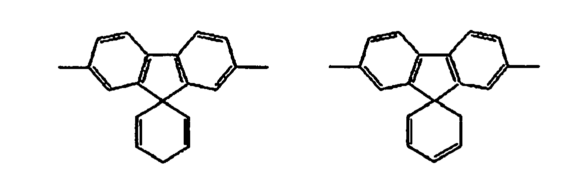

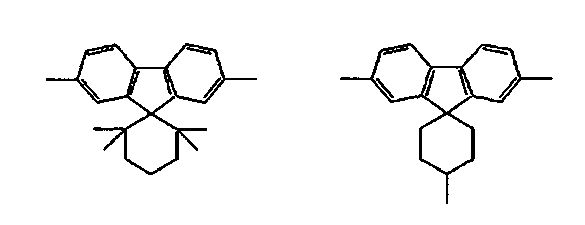

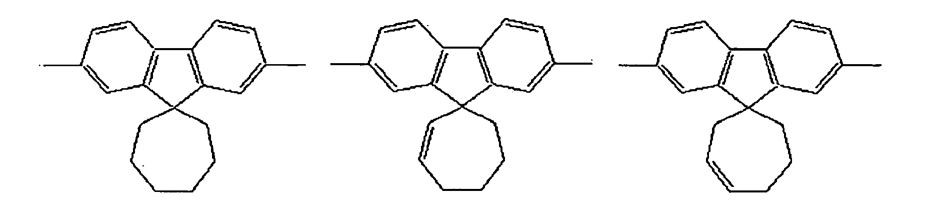

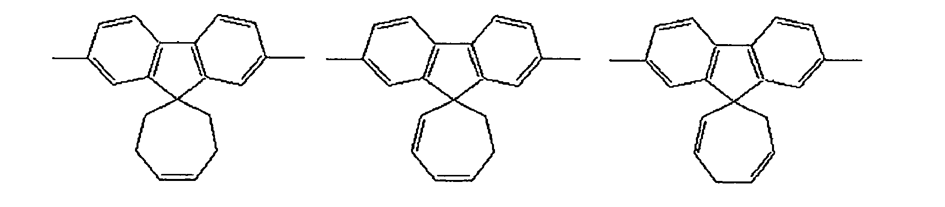

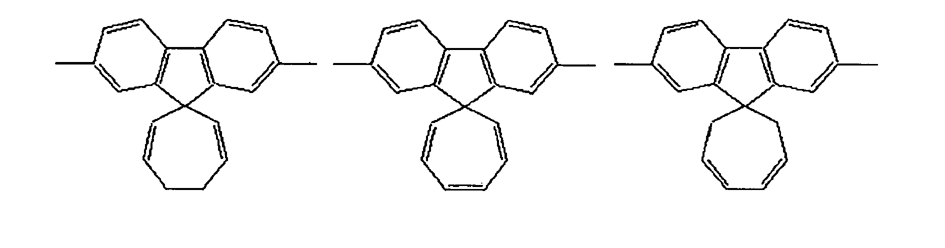

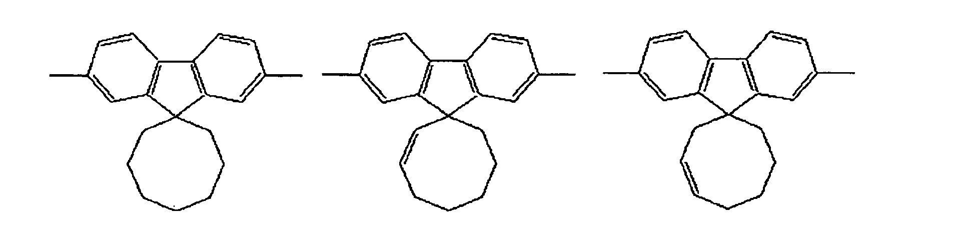

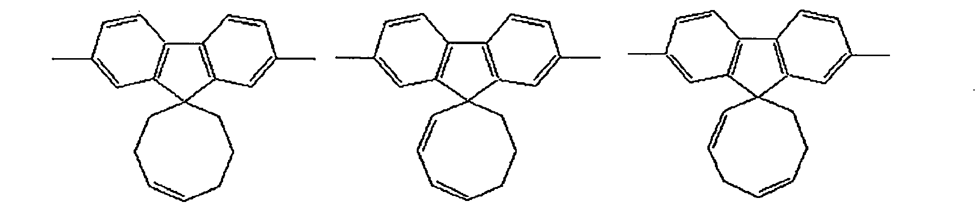

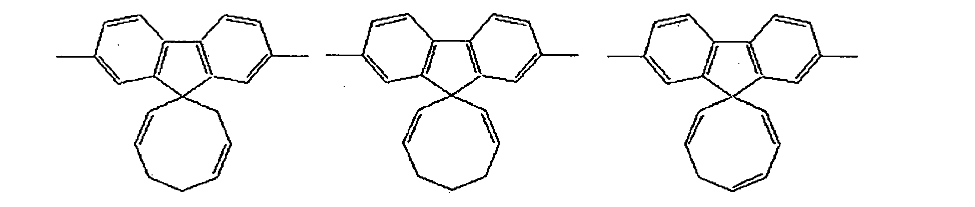

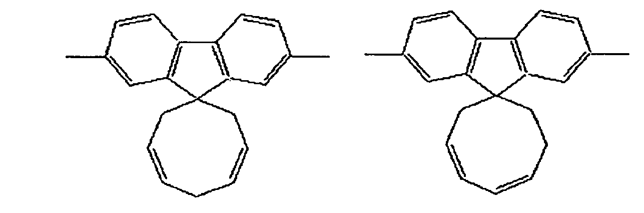

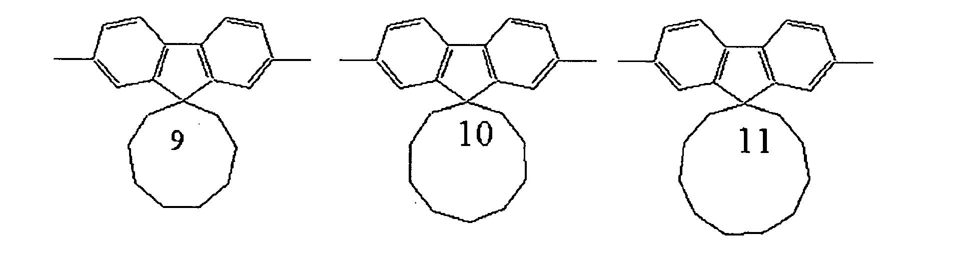

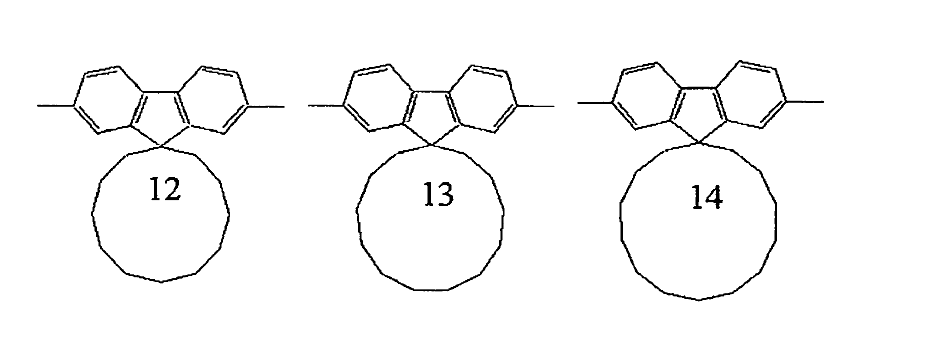

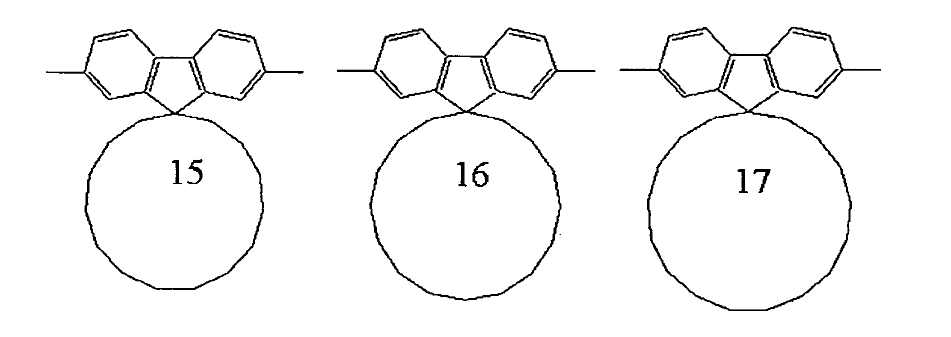

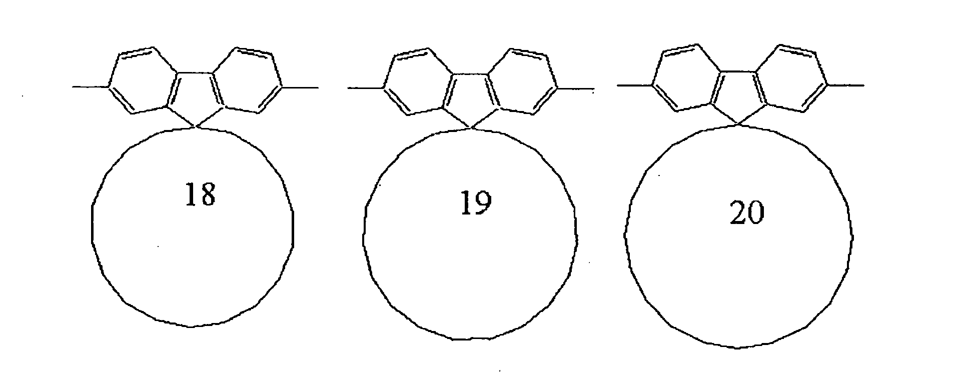

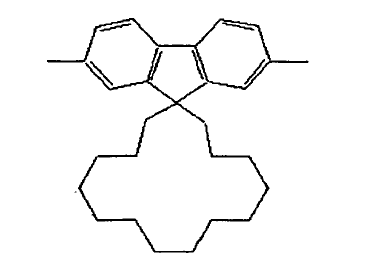

Among them, the following are preferable:

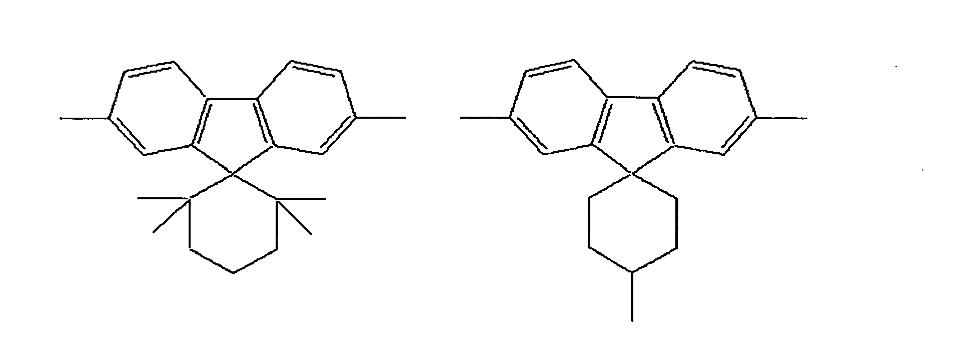

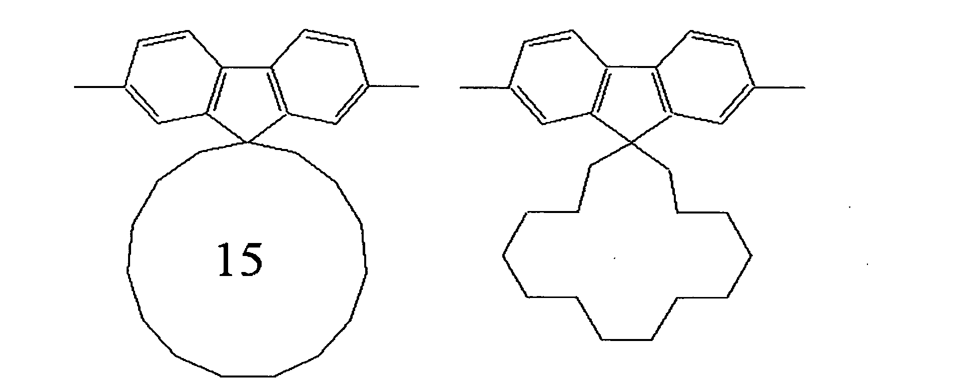

The polymer of the present invention may comprise only one of or two or more of the structures represented by the formula (1a) and the structures represented by the formula (1b).

The polymer of the present invention has a weight-average molecular weight of usually 10³ to 10⁸, preferably 10³ to 10⁷, more preferably 10³ to 10⁶, based on polystyrene standards.

### Structure represented by formula (2)

In the formula (2), the alkyl group represented by R¹, R², R³, R⁴, R⁵, and R⁶ has preferably 1 to 18 carbon atoms. Examples of the alkyl group include methyl, ethyl, n-propyl, isopropyl, n-butyl, isobutyl, sec-butyl, tert-butyl, n-pentyl, n-hexyl, n-octyl, isooctyl, n-decyl, n-dodecyl, n-pentadecyl, and n-octadecyl groups. Some or all of the hydrogen atoms of the alkyl group may be substituted by a fluorine atom.

In the formula (2), the alkoxy group represented by R¹, R², R³, R⁴, R⁵, and R⁶ has preferably 1 to 18 carbon atoms. Examples of the alkoxy group include methoxy, ethoxy, propyloxy, i-propyloxy, butoxy, i-butoxy, t-butoxy, pentyloxy, hexyloxy, cyclohexyloxy, heptyloxy, octyloxy, 2-ethylhexyloxy, nonyloxy, decyloxy, and 3,7-dimethyloctyloxy groups. Hydrogen atoms in the alkoxy group may be substituted partially or wholly by a fluorine atom.

In the formula (2), the aryl group represented by R¹, R², R³, R⁴, R⁵, and R⁶ has preferably 6 to 30 carbon atoms. Examples of the aryl group include phenyl, 1-naphthyl, and 2-naphthyl groups. The aryl group may have a substituent such as a halogen atom, an alkyl group, or an alkoxy group.

Examples of the structure represented by the formula (2) include the following:

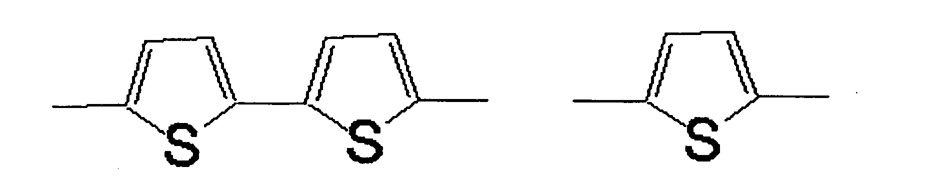

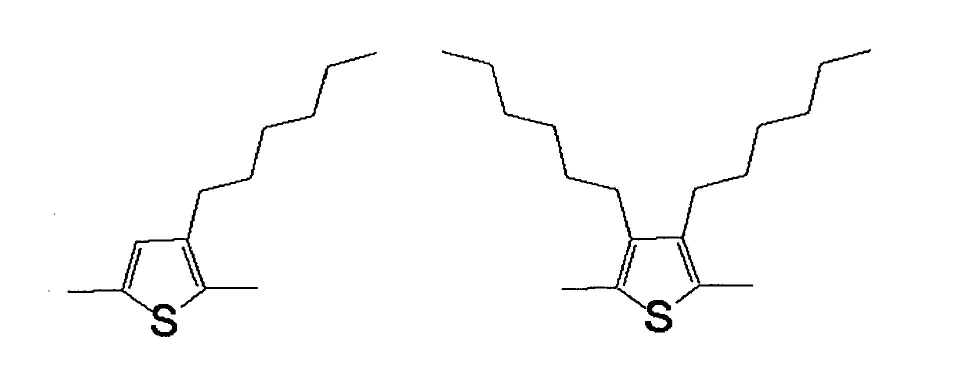

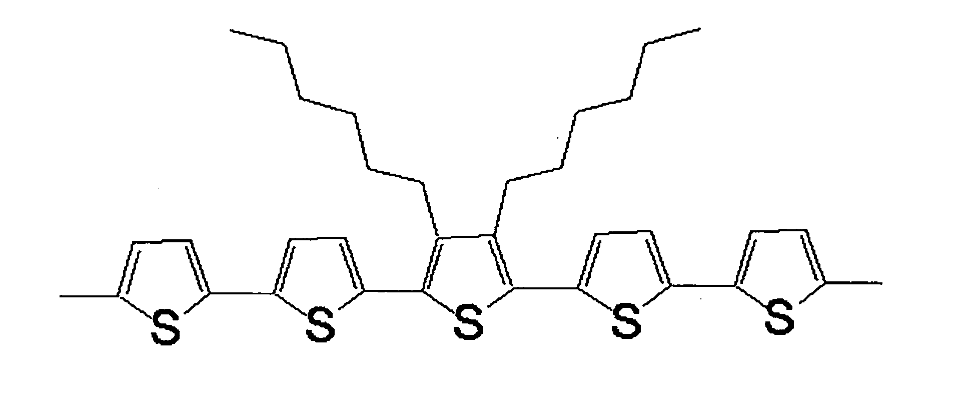

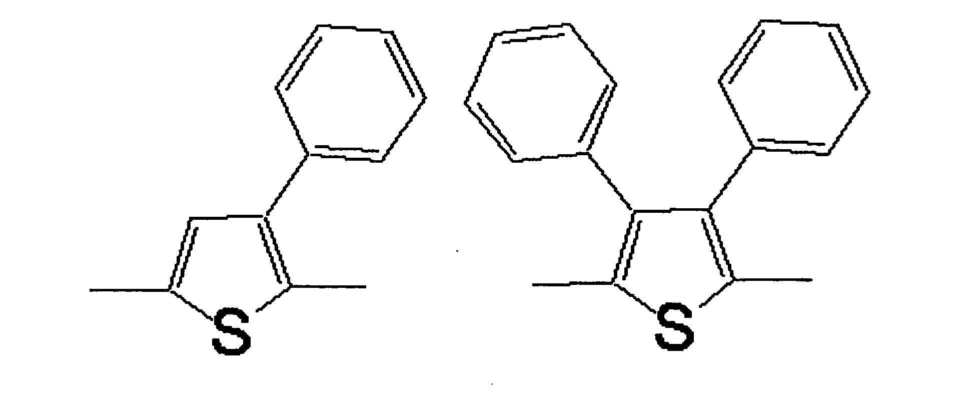

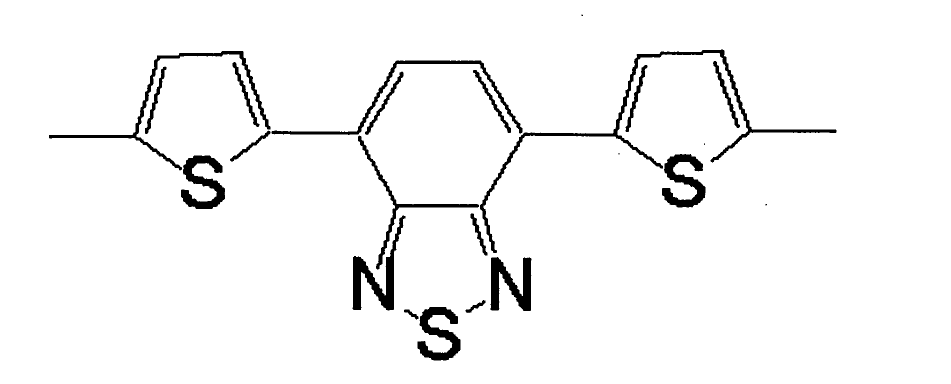

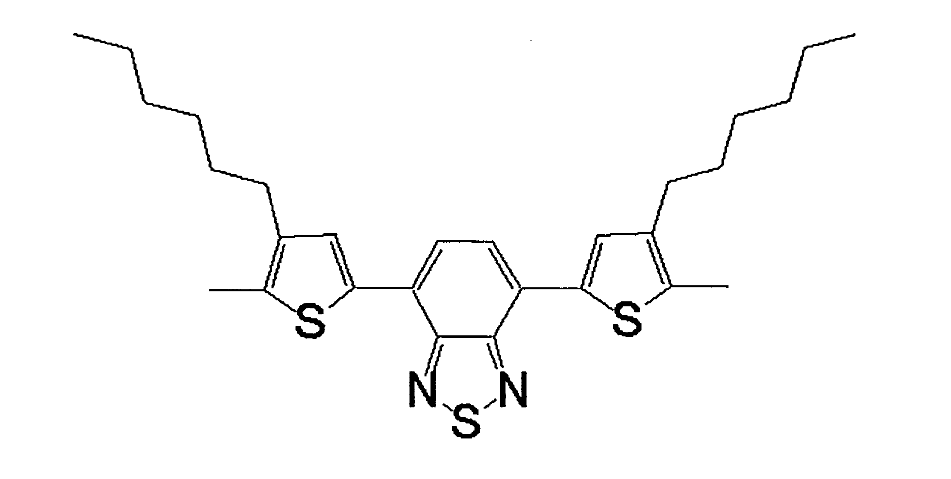

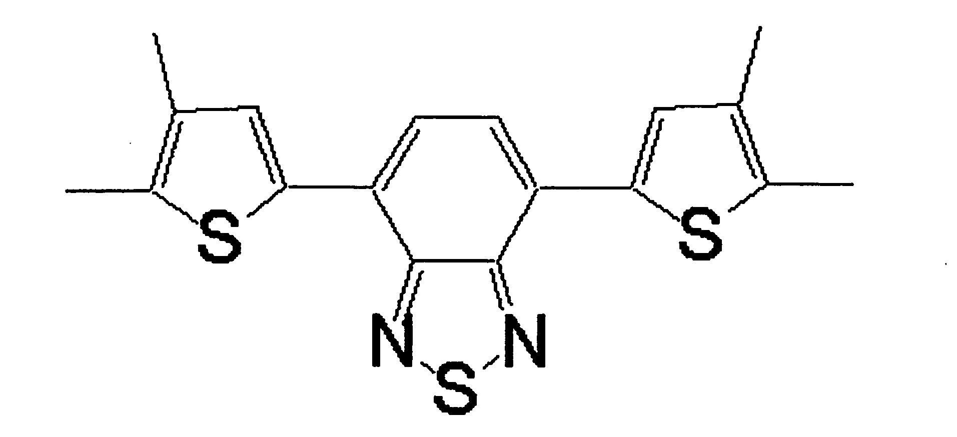

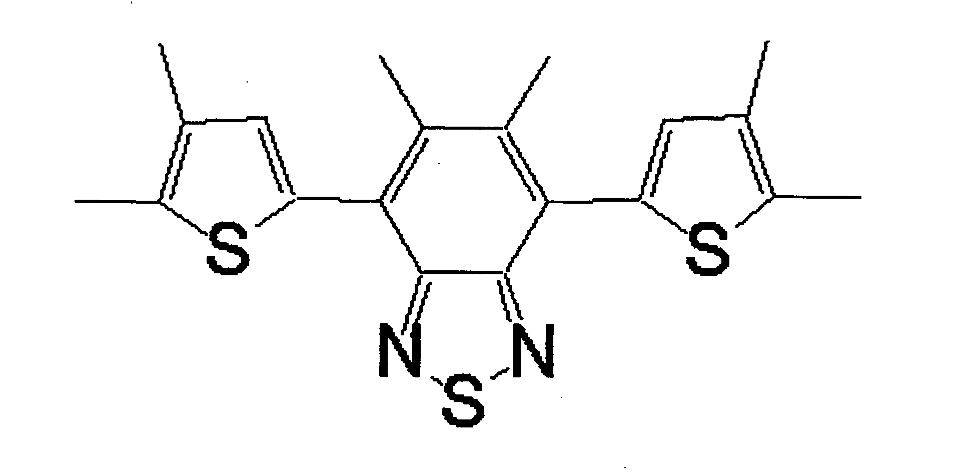

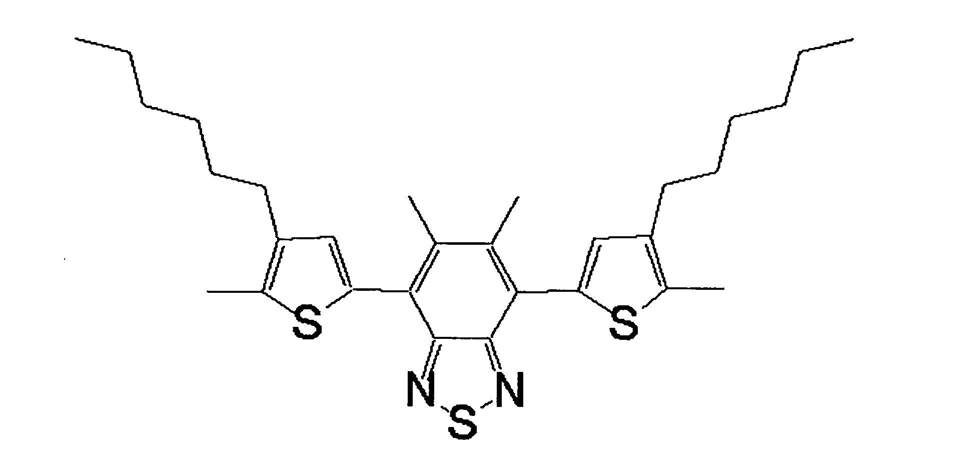

The polymer of the present invention may comprise only one of or two or more of the structures represented by the formula (2).

### Polymer of the present invention

The repeating unit contained in the polymer of the present invention comprises preferably a combination of the structures specifically shown in the paragraph of description of the structures represented by the formulas (1a)/(1b) and the paragraph of description of the structure represented by the formula (2) and is more preferably represented by the following formula (3a) or (3b): 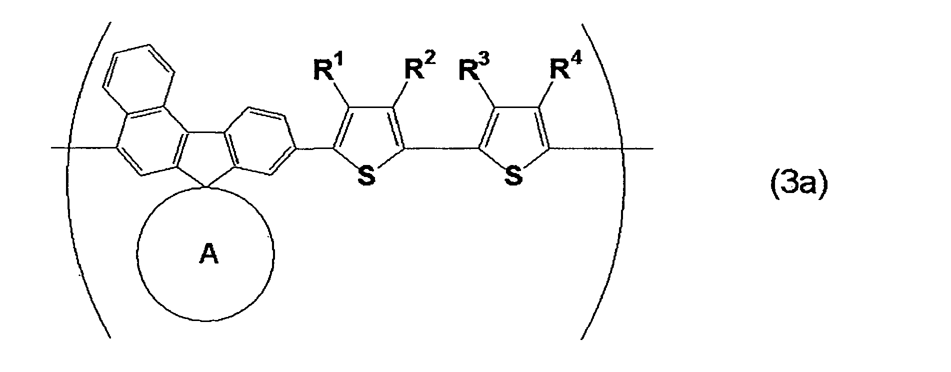 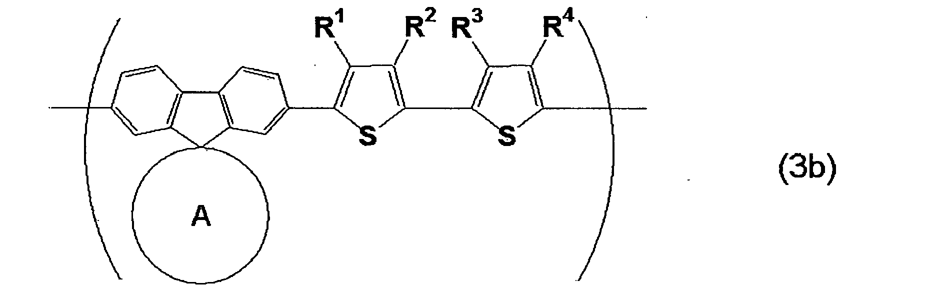 wherein the A ring, R¹, R², R³, and R⁴ are as defined above.

Specific examples of the polymer of the present invention include the following: 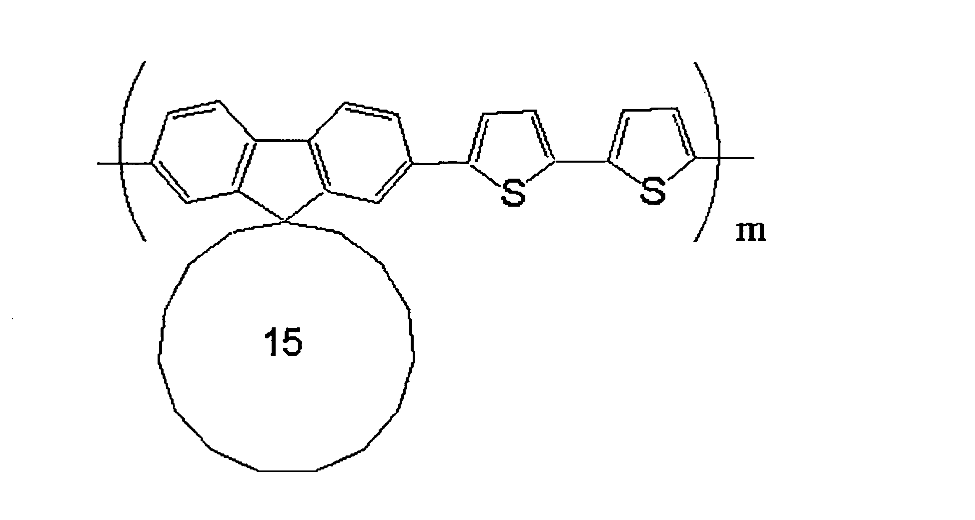 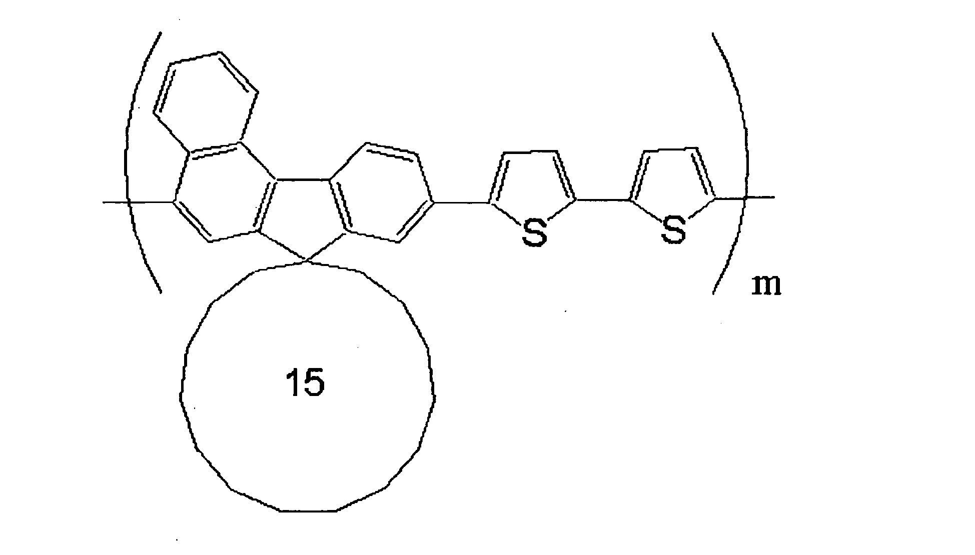 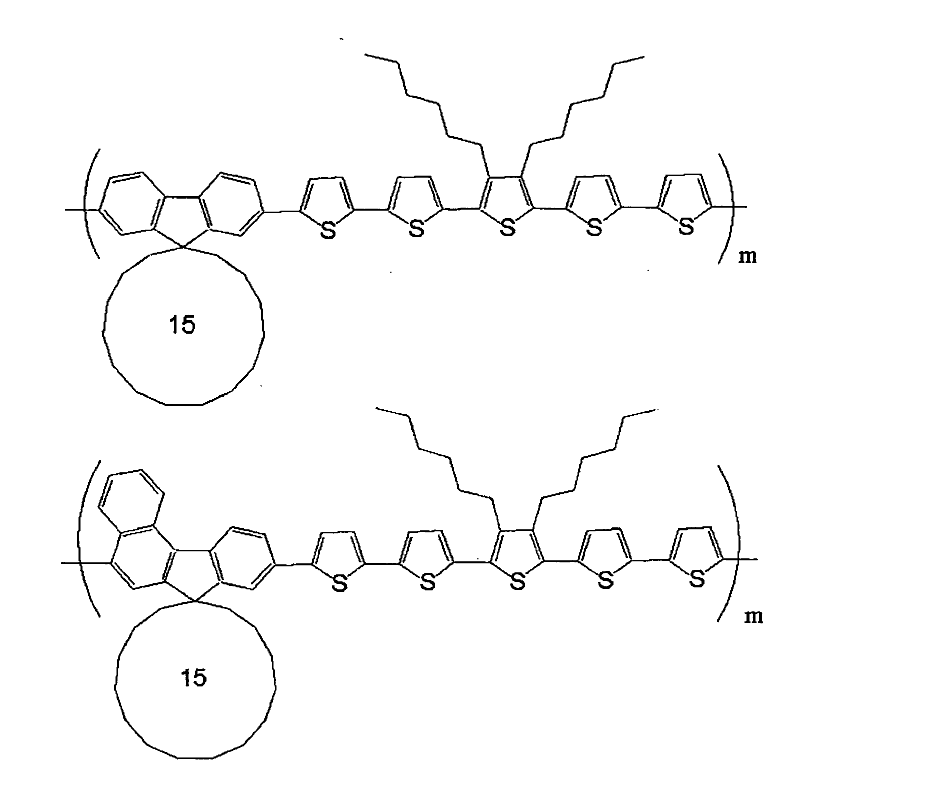 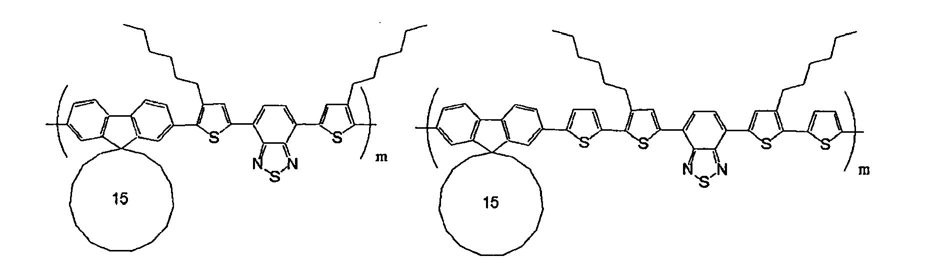 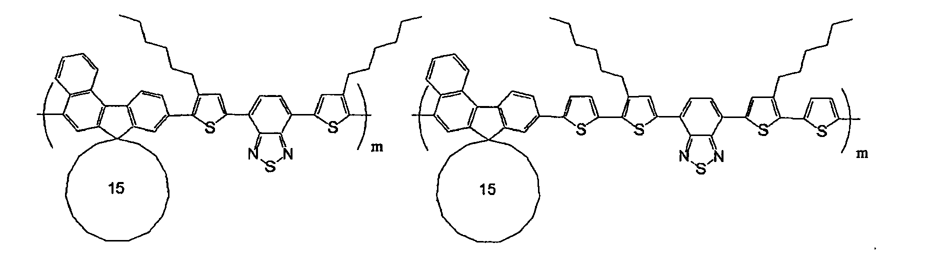 wherein m represents the number of repeating units.

The polymer of the present invention comprises usually 20 to 100% by mol of the repeating unit with respect to all repeating units in the polymer and comprises preferably 50 to 100% by mol of the repeating unit with respect to all repeating units in the polymer from the viewpoint of obtaining high photoelectric conversion efficiency.

### <Method for producing polymer>

The polymer of the present invention may be produced by any method and can be synthesized, for example, by: synthesizing monomers having a functional group suitable for a polymerization reaction used; then, if necessary, dissolving the monomers in an organic solvent; and polymerizing the monomers using a polymerization method through aryl coupling known in the art using an alkali, an appropriate catalyst, a ligand, and so on. The synthesis of the monomers can be performed with reference to a method shown in, for example, Japanese Patent Laid-Open No. 2006-182920 or 2006-335933.

Examples of the polymerization method through aryl coupling include, but not particularly limited to: a method which involves polymerizing a monomer having a boric acid or boric acid ester residue and a monomer having a halogen atom (e.g., bromine, iodine, and chlorine atoms) or a sulfonate group (e.g., trifluoromethanesulfonate and p-toluenesulfonate groups) through Suzuki coupling reaction using a catalyst comprising a palladium or nickel complex (e.g., palladium[tetrakis(triphenylphosphine)], [tris(dibenzylideneacetone)]dipalladium, palladium acetate, bis(triphenylphosphine)palladium dichloride, and bis(cyclooctadiene)nickel) and, if necessary, further, a ligand (e.g., triphenylphosphine, tri(2-methylphenyl)phosphine, tri(2-methoxyphenyl)phosphine, diphenylphosphinopropane, tri(cyclohexyl)phosphine, and tri(tert-butyl)phosphine) in the presence of an inorganic base (e.g., sodium carbonate, potassium carbonate, cesium carbonate, tripotassium phosphate, and potassium fluoride) and/or an organic base (e.g., tetrabutylammonium fluoride, tetrabutylammonium chloride, tetrabutylammonium bromide, and tetraethylammonium hydroxide); a method which involves polymerizing monomers having a halogen atom or a sulfonate group (e.g., a trifluoromethanesulfonate group) through Yamamoto coupling reaction in which the polymerization reaction is performed, if necessary, under dehydrated conditions, using a catalyst comprising a nickel(0) complex (e.g., bis(cyclooctadiene)nickel) and a ligand (e.g., bipyridyl) or using a catalyst comprising a nickel complex (e.g., [bis(diphenylphosphino)ethane]nickel dichloride and [bis(diphenylphosphino)propane]nickel dichloride) and, if necessary, further, a ligand (e.g., triphenylphosphine, diphenylphosphinopropane, tri(cyclohexyl)phosphine, and tri(tert-butyl)phosphine), and a reducing agent (e.g., zinc and magnesium); a method which involves polymerizing a compound having a magnesium halide group and a compound having a halogen atom through Kumada-Tamao coupling reaction in which the polymerization through the aryl coupling reaction is performed under dehydrated conditions using a nickel catalyst (e.g., [bis(diphenylphosphino)ethane]nickel dichloride and [bis(diphenylphosphino)propane]nickel dichloride); a method which involves performing polymerization using an oxidizing agent such as FeCl₃; and a method which involves electrochemically performing oxidative polymerization.

In the polymerization method through aryl coupling, a solvent is usually used. This solvent can be selected in consideration of the polymerization reaction used, the solubility of the monomers and the polymer, and so on. The solvent is specifically exemplified by: organic solvents such as tetrahydrofuran, toluene, 1,4-dioxane, dimethoxyethane, N,N-dimethylacetamide, N,N-dimethylformamide, and mixed solvents of two or more thereof; and two-phase systems of these organic solvents with water. Organic solvents such as tetrahydrofuran, toluene, 1,4-dioxane, dimethoxyethane, N,N-dimethylacetamide, N,N-dimethylformamide, and mixed solvents of two or more thereof, and two-phase systems of these organic solvents with water are preferable for the Suzuki coupling reaction. It is generally preferred that the reaction solvent should be subjected to deoxidation treatment for suppressing side reactions. Organic solvents such as tetrahydrofuran, toluene, 1,4-dioxane, dimethoxyethane, N,N-dimethylacetamide, N,N-dimethylformamide, and mixed solvents of two or more thereof are preferable for the Yamamoto coupling reaction. It is generally preferred that the reaction solvent should be subjected to deoxidation treatment for suppressing side reactions.

Among the polymerization methods through aryl coupling, the Suzuki coupling reaction and the Yamamoto coupling reaction are preferable from the viewpoint of reactivity. The Suzuki coupling reaction and the Yamamoto coupling reaction using a nickel(0) complex are more preferable. More specifically, for the polymerization through the Suzuki coupling, a method known in the art described in, for example, Journal of Polymer Science: Part A: Polymer Chemistry, Vol. 39, 1533-1556 (2001) can be referred to. For the polymerization through the Yamamoto coupling, a method known in the art described in, for example, Macromolecules 1992, 25, 1214-1223 can be referred to.

In the polymerization method through aryl coupling, the reaction temperature is not particularly limited as long as it falls within a range of temperatures at which the reaction solution can be kept liquid. The lower limit thereof is preferably -100°C, more preferably -20°C, particularly preferably 0°C, from the viewpoint of reactivity. The upper limit thereof is preferably 200°C, more preferably 150°C, particularly preferably 120°C, from the viewpoint of stability.

In the polymerization reaction through aryl coupling, the polymer of the present invention can be separated according to a method known in the art from the reaction system after the completion of the reaction. The polymer of the present invention can be obtained, for example, by adding the reaction solution to lower alcohol such as methanol and filtering and drying the deposited precipitate. When the obtained polymer has low purity, it can be purified by a usual method such as recrystallization, continuous extraction using a Soxhlet extractor, and column chromatography.

### <Organic photoelectric converter>

An organic photoelectric converter of the present invention comprises, for example: a pair of electrodes; and a layer having a heterojunction between an electron-accepting compound and an electron-donating compound adjacent to each other, the layer being disposed between the electrodes. Specific examples thereof include:
1. an organic photoelectric converter comprising: a pair of electrodes; a first organic layer containing an electron-accepting compound; the first organic layer being disposed between the electrodes; and a second organic layer containing an electron-donating compound, the second organic layer being disposed adjacent to the first organic layer, wherein the electron-donating compound or the electron-accepting compound is the polymer;
2. an organic photoelectric converter comprising: a pair of electrodes; and at least one organic layer containing an electron-accepting compound and an electron-donating compound, the organic layer being disposed between the electrodes, wherein the electron-donating compound or the electron-accepting compound is the polymer; and
3. an organic photoelectric converter comprising: a pair of electrodes; and at least one organic layer containing an electron-accepting compound and an electron-donating compound, the organic layer being disposed between the electrodes, wherein the electron-donating compound is the polymer, and the electron-accepting compound is a fullerene derivative.
At least one of the pair of electrodes is usually transparent or semitransparent. Hereinafter, the organic photoelectric converter of the present invention will be described by taking such a structure as an example.

Moreover, in the organic photoelectric converter 3., the organic layer containing an electron-accepting compound and an electron-donating compound contains the electron-accepting compound in an amount of preferably 10 to 1000 parts by weight, more preferably 50 to 500 parts by weight, per 100 parts by weight of the electron-donating compound.

Next, the operating mechanism of the organic photoelectric converter will be described. The energy of incident light through the transparent or semitransparent electrode is adsorbed by the electron-accepting compound and/or the electron-donating compound to form excitons comprising electrons bound with holes. When the formed excitons move and reach the heterojunction interface between the electron-accepting compound and the electron-donating compound adjacent to each other, the excitons dissociate into the electrons and the holes owing to difference in their respective HOMO and LUMO energies at the interface such that independently movable charges (electrons and holes) are formed. The formed charges respectively move toward the electrodes and can be supplied to the outside as electric energy (electric current).

For high photoelectric conversion efficiency of the organic photoelectric converter, the following are important: the electron-accepting compound and the electron-donating compound have an absorption range within which the spectrum of the desired incident light can be absorbed efficiently; many heterojunction interfaces are contained therein for the efficient dissociation of the excitons at the heterojunction interface; and the heterojunction interface has charge transport properties for immediately transporting the formed charges to the electrodes.

From such a viewpoint, the organic photoelectric converter of the present invention is preferably the organic photoelectric converter 2. or 3. and is more preferably the organic photoelectric converter 3. from the viewpoint of containing many heterojunction interfaces. Moreover, the organic photoelectric converter of the present invention may be provided with an additional layer at least between one of the electrodes and the organic layer in the device. Examples of the additional layer include charge transport layers which transport holes or electrons.

The organic photoelectric converter of the present invention is usually formed on a substrate. This substrate can be any substrate that does not change when the electrodes and the organic layer(s) are formed thereon. Examples of materials for the substrate include glass, plastics, polymer films, and silicon. For an opaque substrate, it is preferred that the electrode on the opposite side (i.e., the electrode disposed far from the substrate) should be transparent or semitransparent.

Examples of materials for the transparent or semitransparent electrode include conductive metal oxide films and semitransparent metal thin films. Specifically, for example, a film (NESA, etc.) prepared using conductive glass comprising indium oxide, zinc oxide, tin oxide, and their complex indium tin oxide (ITO) or indium zinc oxide, or the like, or gold, platinum, silver, or copper is used. ITO, indium zinc oxide, and tin oxide are preferable. Examples of a method for preparing the electrode include vacuum deposition, sputtering, ion plating, and plating methods. Moreover, transparent organic conductive films such as polyaniline and derivatives thereof and polythiophene and derivatives thereof may be used as electrode materials. Furthermore, metals, conductive polymers, and the like can be used as electrode materials. Preferably, one of the pair of electrodes is made of a material having a small work function. Examples of the material used include: metals such as lithium, sodium, potassium, rubidium, cesium, magnesium, calcium, strontium, barium, aluminum, scandium, vanadium, zinc, yttrium, indium, cerium, samarium, europium, terbium, and ytterbium, and alloys of two ore more thereof or alloys of one or more thereof with one or more of gold, silver, platinum, copper, manganese, titanium, cobalt, nickel, tungsten, and tin; and graphite or intercalated graphite. Examples of the alloys include magnesium-silver, magnesium-indium, magnesium-aluminum, indium-silver, lithium-aluminum, lithium-magnesium, lithium-indium, and calcium-aluminum alloys.

An electron-donating compound and an electron-accepting compound described later can be used as materials used in the charge transport layers, i.e., a hole transport layer and an electron transport layer, respectively, as the additional layer. Halides, oxides, and the like of alkali metals or alkaline-earth metals such as lithium fluoride can be used as materials for a buffer layer as the additional layer. Moreover, fine particles of inorganic semiconductors such as titanium oxide can also be used.

### Organic thin film

For example, an organic thin film containing the polymer of the present invention can be used as the organic layer (organic layer containing the polymer of the present invention) in the organic photoelectric converter of the present invention.

The organic thin film has a film thickness of usually 1 nm to 100 µm, preferably 2 nm to 1000 nm, more preferably 5 nm to 500 nm, even more preferably 20 nm to 200 nm.

The organic thin film may contain only one of the polymers of the present invention alone or two or more thereof in combination. Moreover, for higher hole transport properties of the organic thin film, a mixture of a low-molecular compound and/or a polymer other than the polymer of the present invention with the polymer of the present invention can also be used as the electron-donating compound and/or the electron-accepting compound in the organic thin film.

Examples of the electron-donating compound include, in addition to the polymer of the present invention, pyrazoline derivatives, arylamine derivatives, stilbene derivatives, triphenyldiamine derivatives, oligothiophene and derivatives thereof, polyvinylcarbazole and derivatives thereof, polysilane and derivatives thereof, polysiloxane derivatives having aromatic amine in the side chain or the main chain, polyaniline and derivatives thereof, polythiophene and derivatives thereof, polypyrrole and derivatives thereof, poly(phenylene vinylene) and derivatives thereof, and poly(thienylene vinylene) and derivatives thereof.

Examples of the electron-accepting compound include, in addition to the polymer of the present invention, oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, fullerenes such as C₆₀ and derivatives thereof, and phenanthrene derivatives such as bathocuproine. Particularly, fullerenes and derivatives thereof are preferable.

In this context, the electron-donating compound and the electron-accepting compound are relatively determined based on the energy levels of these compounds.

Examples of the fullerenes include C₆₀, C₇₀, carbon nanotube, and derivatives thereof. Examples of the specific structures of the derivatives include the following:

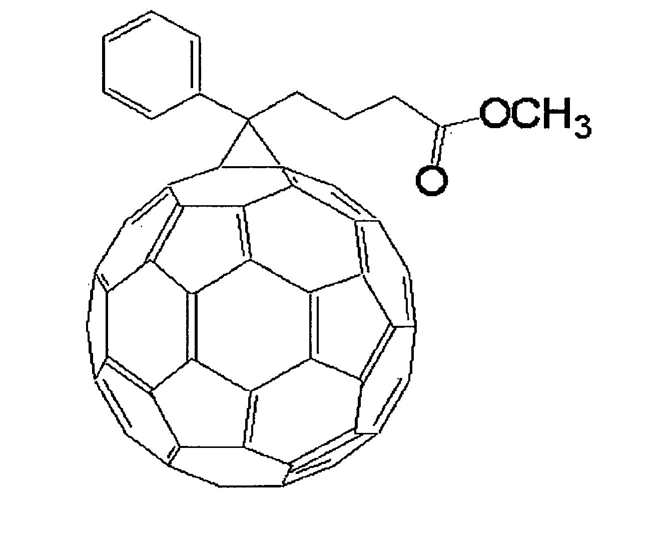

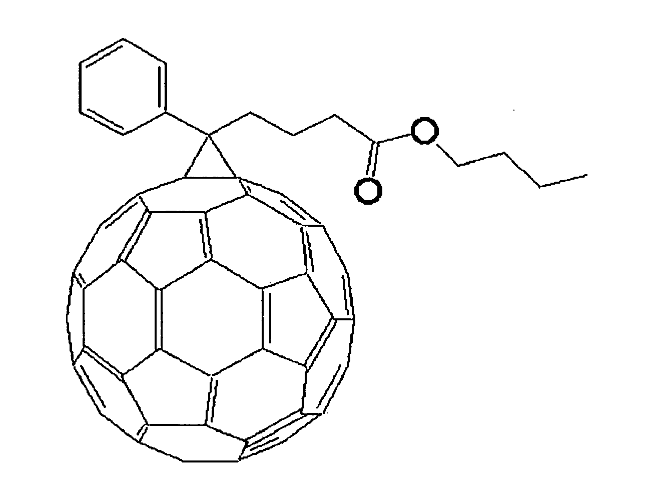

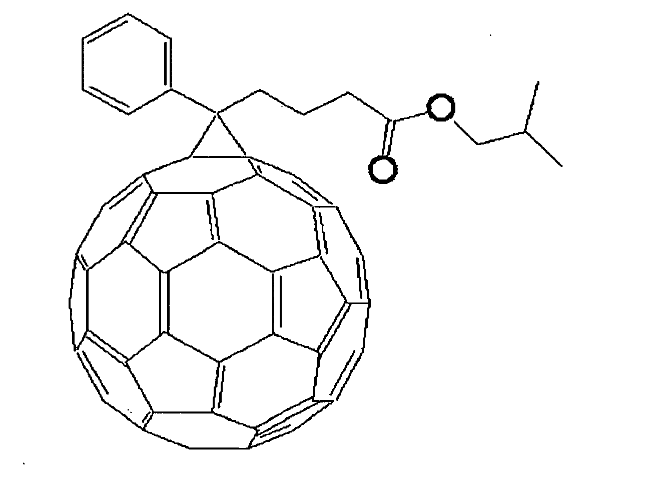

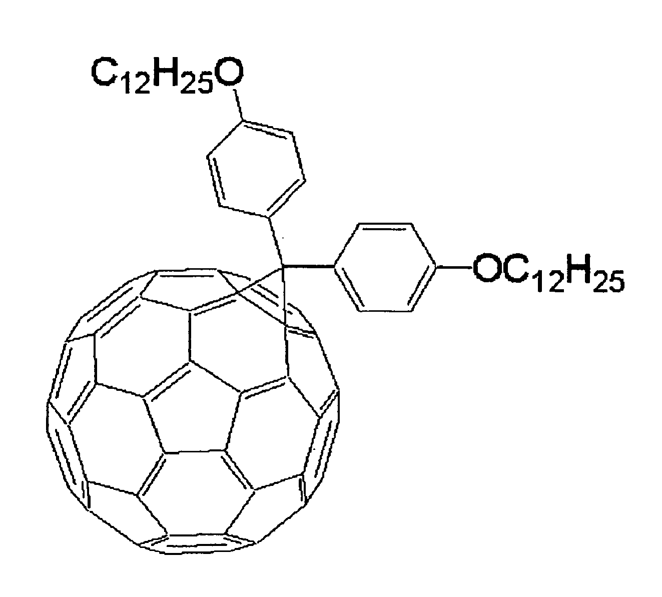

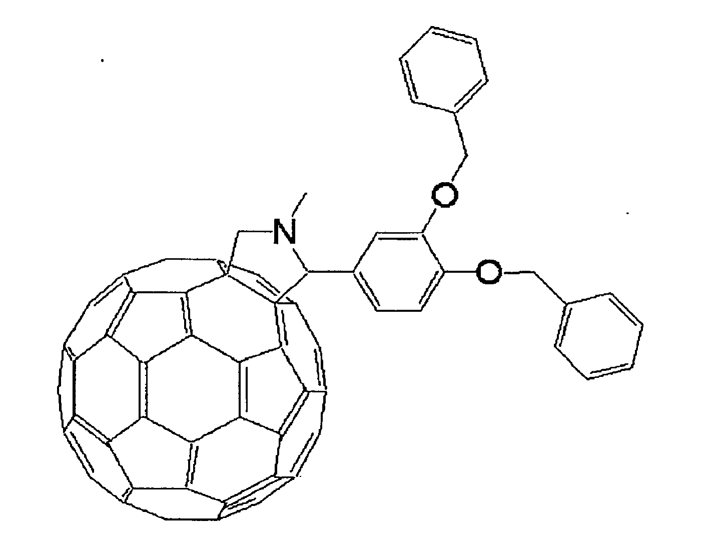

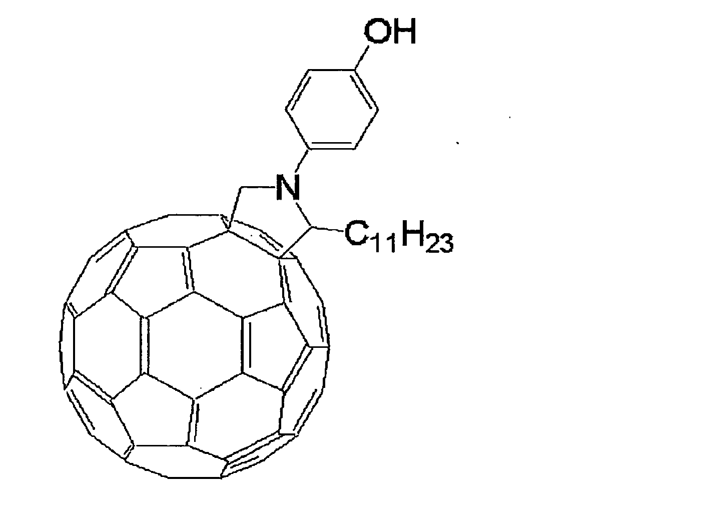

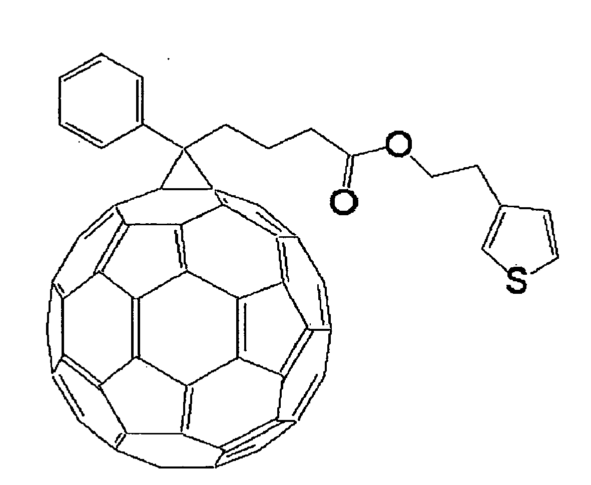

### Method for producing organic thin film

The organic thin film may be produced by any method and may be produced, for example, by a method which involves film formation from a solution containing the polymer of the present invention or thin film formation by a vacuum deposition method.

A solvent used in the film formation from a solution is not particularly limited as long as it dissolves therein the polymer of the present invention. Examples of this solvent include: unsaturated hydrocarbon solvents such as toluene, xylene, mesitylene, tetralin, decalin, bicyclohexyl, n-butylbenzene, sec-butylbenzene, and tert-butylbenzene; halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane; halogenated unsaturated hydrocarbon solvents such as chlorobenzene, dichlorobenzene, and trichlorobenzene; and ether solvents such as tetrahydrofuran and tetrahydropyran. The solvent can usually dissolve therein 0.1% by weight or more of the polymer of the present invention.

Application methods such as spin coating, casting, micro-gravure coating, gravure coating, bar coating, roll coating, wire bar coating, dip coating, spray coating, screen printing, flexography, offset printing, inkjet printing, dispenser printing, nozzle coating, and capillary coating methods can be used in the film formation from a solution. Spin coating, flexography, inkjet printing, and dispenser printing methods are preferable.

The organic photoelectric converter generates photoelectromotive force between the electrodes upon irradiation with light (e.g., sunlight) through the transparent or semitransparent electrode. Thus, the organic photoelectric converter can be operated as an organic thin-film solar cell. A plurality of the organic thin-film solar cells can also be integrated and thereby used as an organic thin-film solar cell module.

Moreover, photocurrent flows upon irradiation with light through the transparent or semitransparent electrode with voltage applied between the electrodes. Thus, the organic photoelectric converter can be operated as an organic photosensor. A plurality of the organic photosensors can also be integrated and thereby used as an organic image sensor.

### <Use of device>

A plurality of the organic photoelectric converters of the present invention can be integrated such that they constitute an organic thin-film solar cell module or an organic image sensor.

### Examples

Hereinafter, the present invention will be described more specifically with reference to Examples. However, the present invention is not intended to be limited to them.

Number-average molecular weights based on polystyrene standards were determined by size exclusion chromatography (SEC).

Column: TOSOH TSK-gel Super HM-H (two columns)+TSK-gel Super H2000 (4.6 mm i.d. × 15 cm); Detector: RI (SHIMADZU RID-10A); and Mobile phase: tetrahydrofuran (THF)

### <Synthesis Example 1> (Synthesis of compound C)

To a three-neck round-bottom flask (500 ml), 25.1 g of 2-bromoiodobenzene, 20.0 g of naphthaleneboronic acid, 0.427 g of tetrakis(triphenylphosphine)palladium(0), and 25.5 g of potassium carbonate were added. Then, 92 ml of toluene and 91 ml of water were added thereto, and the mixture was heated to reflux. After stirring for 24 hours, the mixture was cooled to room temperature. The reaction solution was applied to a silica gel for filtration, and the solvent was distilled off to obtain 25 g of a crude product. The crude product was purified by silica gel column chromatography, and then, the purified product was recrystallized from hexane to obtain, in a white solid form, 12.2 g of a compound A represented by the following formula:

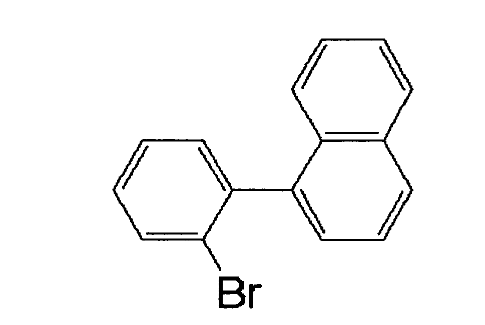

The air in a 300-ml three-neck flask was replaced by nitrogen, and 5.00 g (17.7 mmol) of the compound A was added thereto and dissolved in 100 ml of THF. After cooling to -78°C, 12.6 ml of n-butyllithium (1.54 M solution in hexane, 19.4 mmol) was added dropwise thereto. After incubation for 30 minutes, a solution containing 4.75 g (21.2 mmol) of cyclopentadecanone dissolved in 25 ml of THF was added dropwise thereto. After incubation for 5 minutes, the cold bath was removed, and the mixture was heated to room temperature and incubated for 8 hours. 1 ml of water and 100 ml of toluene were added thereto, and the mixture was applied to a glass filter covered with a silica gel for filtration. The solvent was distilled off to obtain 8.99 g of a crude product. The crude product was purified by silica gel column chromatography (developing solvent: hexane:ethyl acetate=40:1) to obtain 5.18 g of a compound B represented by the following formula:

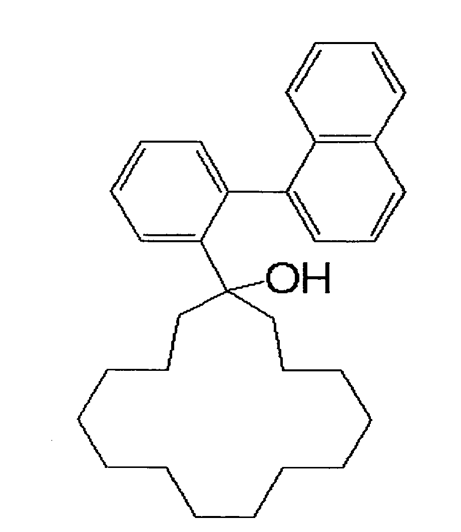

A 200-ml two-neck flask was charged with a boron trifluoride-ether complex in a nitrogen atmosphere. 25 ml of dichloromethane was added thereto, and the mixture was stirred. A solution containing 5 g of the compound B dissolved in 50 ml of dichloromethane was added thereto with cooling in a water bath. After stirring for 1 hour, the reaction was terminated by the addition of 100 ml of water, followed by two extractions with 50 ml of chloroform. The obtained organic phase was applied to a precoated silica gel for filtration to obtain 4.1 g of a compound C represented by the following formula: 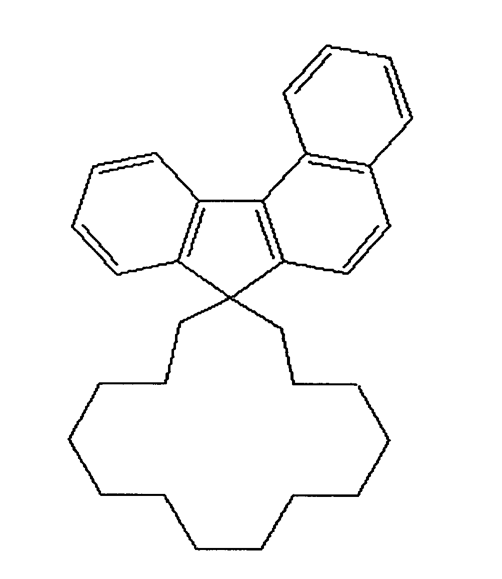 In this context, this mixture was used in next reaction without being further purified.
¹H-NMR (300 MHz/CDCl₃):
δ1.30-1.52 (m, 24H), 1.85 (q, 4H), 7.33 (t, 1H), 7.43 (d, 1H), 7.50 (t, 1H), 7.58-7.65 (m, 2H), 7.68 (d, 1H), 7.82 (d, 1H), 7.94 (d, 1H), 8.36 (d, 1H), 8.76 (d, 1H)

### <Synthesis Example 2> (Synthesis of compound D)

A 300-ml three-neck flask was charged with 4.6 g of the compound C in a nitrogen atmosphere. The compound was dissolved by the addition of 50 ml of dichloromethane. To the solution, 70 ml of acetic acid was added, and the mixture was heated to 50°C in an oil bath. 3.35 g of zinc chloride was added thereto with heating, and the mixture was stirred. A solution containing 9.61 g of benzyltrimethylammonium tribromide dissolved in 21 ml of dichloromethane was added thereto over 30 minutes while the mixture was heated to reflux. The mixture was further stirred at 50°C for 1 hour and then cooled to room temperature. Subsequently, the reaction was terminated by the addition of 100 ml of water. After separation into aqueous and organic phases, the aqueous phase was subjected to extraction with 50 ml of chloroform, and these organic phases were combined. The combined organic phase was washed with 100 ml of an aqueous saturated sodium thiosulfate solution, then 150 ml of an aqueous saturated sodium bicarbonate solution, and finally 100 ml of water. The obtained organic phase was applied to a precoated silica gel for filtration to obtain 6.8 g of a crude product. This mixture was purified by silica gel column chromatography to obtain 1.98 g of a compound D represented by the following formula: 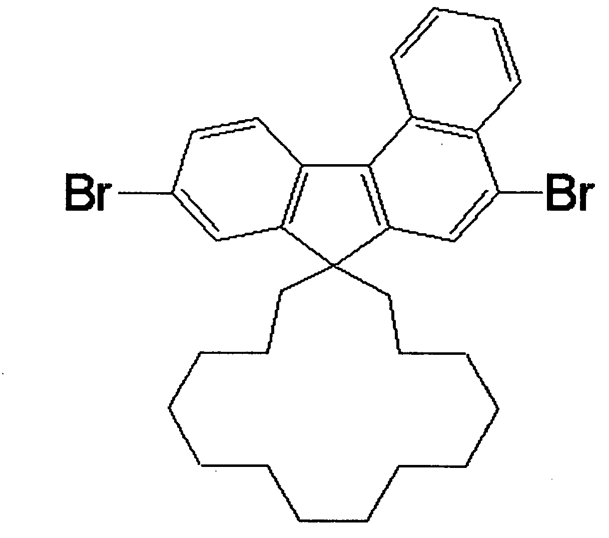 ¹H-NMR (300 MHz/CDCl₃):
δ1.26-1.6 (m, 24H), 1.76 (q, 4H), 7.55 (dd, 1H), 7.5807.71 (m, 2H), 7.68 (S, 1h), 7.96 (S, 1h), 8.17 (d, 1H), 8.38 (dd, 1H), 8.67 (d, 1H)

### <Synthesis Example 3> (Synthesis of compound F)

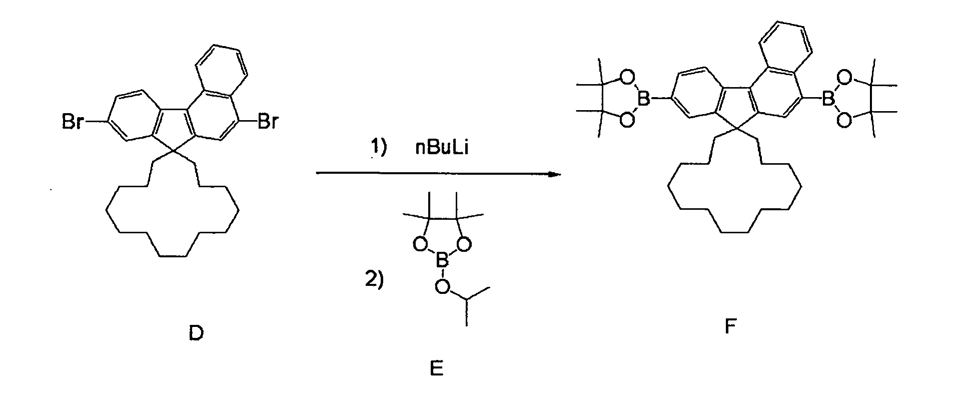

A 100-mL three-neck flask was charged with 7.24 g (12.7 mmol) of the compound D and 50 mL of anhydrous tetrahydrofuran in a nitrogen atmosphere, and the mixture was cooled to -78°C with stirring. 17.6 mL (28.0 mmol) of a 1.59 M solution of n-butyllithium in hexane was added dropwise thereto over 30 minutes, and the mixture was further stirred at -70°C for 5 hours. To the obtained solution, 6.8 g (36.5 mmol) of a compound E was added dropwise over 30 minutes, and then, the mixture was heated to room temperature and stirred overnight at this temperature. To the obtained solution, 1 mL of a 1 N aqueous hydrochloric acid solution was added, and the mixture was stirred. Then, the obtained reaction solution was added dropwise to 50 mL of water. Subsequently, the obtained solution was subjected to two extractions with 100 mL of ethyl acetate. The obtained organic phase was dried over anhydrous sodium sulfate and then concentrated in an evaporator to obtain 4.44 g of a crude crystal. This crystal was recrystallized from a hexane/methanol system to obtain 4.27 g of a boric acid ester form (compound F) (yield: 50.8%).
¹H-NMR (270 MHz/CDCl₃):
δ1.40 (s, 24H), 1.30-1.56 (m, 24H), 1.83-1.93 (m, 4H), 7.56 (t, 1H), 7.62 (t, 1H), 7.91 (d, 1H), 7.97 (s, 1H), 8.26 (s, 1H), 8.37 (d, 1H), 8.80(d, 1H), 8.88 (d, 1H)

### <Synthesis Example 4> (Synthesis of polymer compound 1)

A three-neck flask was charged with 1.15 g (1.75 mmol) of the compound F, 0.57 g (1.75 mmol) of 5,5'-dibromo-2,2'-bithiophene, 0.88 mg of dichlorobis(triphenylphosphine)palladium(II), and 0.2 g of methyltrioctylammonium chloride (trade name: Aliquat 336, manufactured by Sigma-Aldrich Inc., CH₃N[(CH₂)₇CH₃]₃Cl, density: 0.884 g/ml (25°C)) in a nitrogen atmosphere. 18 ml of toluene bubbled with nitrogen in advance for 30 minutes was added thereto. The obtained solution was heated to 105°C, and 3.23 ml of a 2 mol/l aqueous sodium carbonate solution was added dropwise thereto. After the completion of the dropwise addition, the obtained solution was heated to reflux for 4 hours. To the obtained solution, 0.02 g of phenylboronic acid was added, and the mixture was further heated to reflux for 5 hours. Then, 0.5 g of sodium N,N-diethyldithiocarbamate trihydrate and 6.18 ml of ion-exchanged water were added thereto, and the mixture was stirred at 90°C for 3 hours. After cooling to room temperature, the aqueous phase was removed, and the organic phase was washed three times with 30 ml of ion-exchanged water at 60°C, three times with 2% by weight of an aqueous acetic acid solution, and three times with ion-exchanged water at 60°C. The organic phase was purified with a silica gel-alumina column, and the purified product was precipitated in methanol to obtain 0.79 g of a polymer compound 1 represented by the following formula: 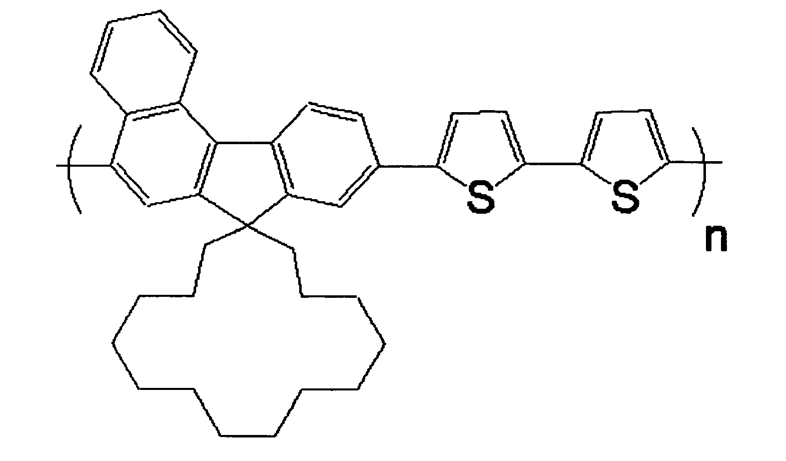 wherein n represents the number of repeating units.
The polymer compound 1 had a number-average molecular weight Mn of 2.3×10⁴ based on polystyrene standards and a weight-average molecular weight Mw of 3.7×10⁴ based on polystyrene standards.

### <Synthesis Example 5> (Synthesis of polymer compound 2)

The compound D (0.568 g) and 2,2'-bipyridyl (0.422 g) were dissolved in 72 mL of dehydrated tetrahydrofuran. Subsequently, to the obtained solution, bis(1,5-cyclooctadiene)nickel(0) {Ni(COD)₂} (0.743 g) was added in a nitrogen atmosphere, and the mixture was stirred and heated to 60°C, followed by reaction for 3 hours. The obtained reaction solution was cooled to room temperature and added dropwise to a mixed solution of 4 mL of 25% by weight of ammonia water/72 mL of methanol/72 mL of ion-exchanged water, and the mixture was stirred for 1 hour. Then, the deposited precipitate was filtered, dried under reduced pressure, and dissolved in 60 ml of toluene. To the obtained solution, 4.6 g of radiolite was added, and the mixture was stirred for 2.5 hours. The undissolved matter was filtered off. The obtained filtrate was applied to an alumina column for purification. Next, to the obtained organic phase, 110 mL of 5.2% by weight of an aqueous hydrochloric acid solution was added, and the mixture was stirred for 3 hours, followed by removal of the aqueous phase. Subsequently, to the obtained organic phase, 110 mL of 4% by weight of ammonia water was added, and the mixture was stirred for 2 hours, followed by removal of the aqueous phase. Furthermore, to the obtained organic phase, approximately 110 mL of ion-exchanged water was added, and the mixture was stirred for 1 hour, followed by removal of the aqueous phase. Then, the obtained organic phase was concentrated under reduced pressure to 30 ml. 90 ml of methanol was poured thereto, and the mixture was stirred for 0.5 hours. The deposited precipitate was filtered and dried under reduced pressure. In this way, 0.12 g of a polymer compound 2 represented by the following formula: 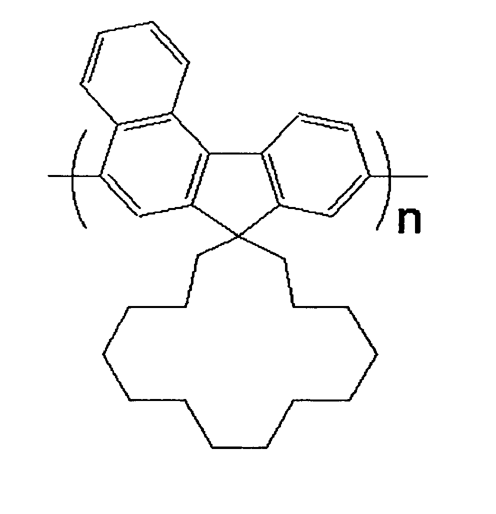 wherein n represents the number of repeating units, was obtained. The polymer compound 2 had a number-average molecular weight Mn of 3.1×10⁴ based on polystyrene standards and a weight-average molecular weight Mw of 4.0×10⁵ based on polystyrene standards.

### <Synthesis Example 6> (Synthesis of compound K)

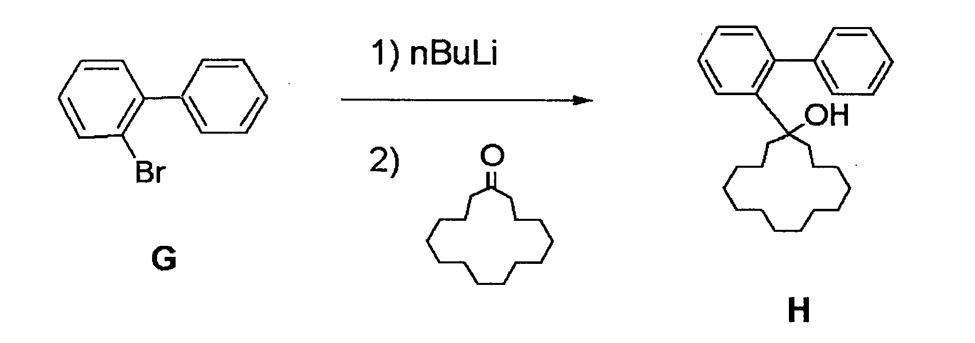

A 500-mL three-neck flask was charged with a compound G (15 g, 64.4 mmol) and 120 ml of anhydrous tetrahydrofuran in a nitrogen atmosphere, and the mixture was cooled to -70°C. 44.5 ml (70.8 mmol) of a 1.59 M solution of n-butyllithium in hexane was added dropwise thereto over 30 minutes, and the mixture was stirred at the same temperature as above for 2 hours. 17.3 g (77.1 mmol) of cyclopentadecanone was added dropwise thereto over 30 minutes, and then, the mixture was heated to room temperature and stirred overnight at this temperature. The obtained reaction solution was added dropwise to 200 ml of an aqueous saturated ammonium chloride solution, followed by two extractions with 100 ml of ethyl acetate. The obtained organic phase was washed with 100 ml of water. The obtained organic phase was dried over anhydrous magnesium sulfate and then concentrated in an evaporator. The obtained residue was subjected to silica gel chromatography (hexane/ethyl acetate=95/5 (volume ratio)), and each fraction was analyzed by high-performance liquid chromatography (HPLC), and fractions having 90% or higher HPLC purity were collected and concentrated in an evaporator to obtain 4.15 g of a compound H in an oil form.

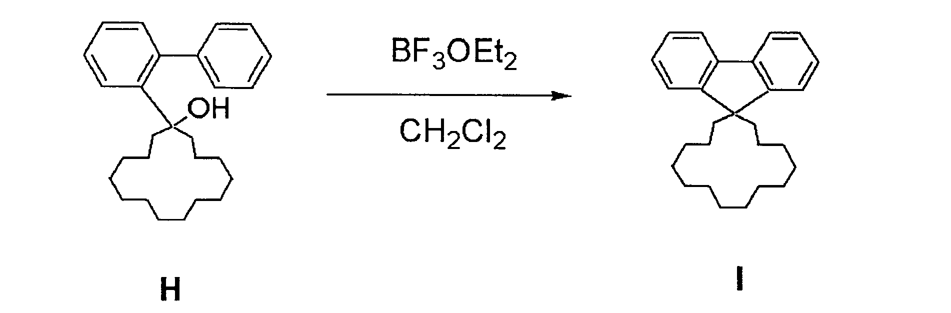

A solution containing 4.15 g of the compound H dissolved in 50 ml of dichloromethane was gradually added to 100 ml of a dichloromethane solution of 15.6 g (110 mmol) of a boron trifluoride-diethyl ether complex cooled to 0°C, and the mixture was stirred at room temperature for 1 hour. The reaction was terminated by the addition of 100 ml of water, followed by extraction with 100 ml of chloroform. The organic phase was dried over anhydrous magnesium sulfate and then concentrated in an evaporator. The obtained residue was purified by silica gel chromatography (developing solvent: hexane) to obtain 3.65 g (10.1 mmol) of a compound I in an oil form.
¹H-NMR (270 MHz/CDCl₃):
δ1.30-1.70 (m, 24H), 1.70-1.82 (m, 4H), 7.31 (t, 2H), 7.33 (t, 2H), 7.59 (d, 2H), 7.72 (d, 2H)

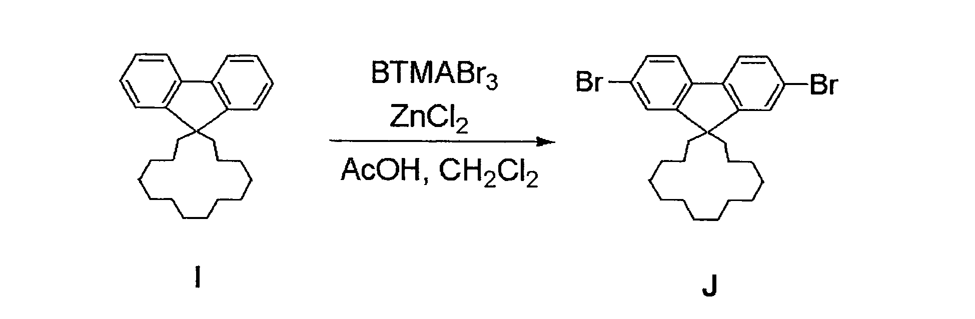

To a 100-ml three-neck flask, 3.65 g (10.1 mmol) of the compound I and 12.5 ml of dichloromethane were added in a nitrogen atmosphere. 50 ml of acetic acid was further added thereto, and then, the mixture was heated to 50°C. 2.9 g (21.3 mmol) of zinc chloride was added thereto with heating, and the mixture was stirred. Then, a solution containing 8.26 g (21.2 mmol) of benzyltrimethylammonium tribromide dissolved in 12.5 ml of dichloromethane was added thereto over 90 minutes while the mixture was heated to reflux. The solution thus obtained was further stirred at 50°C for 30 minutes and then cooled to room temperature. The reaction was terminated by the addition of 50 ml of water to the obtained solution. The obtained solution was subjected to extraction with 30 ml of chloroform. The obtained organic phase was washed with 50 ml of an aqueous saturated sodium thiosulfate solution, then 50 ml of an aqueous saturated sodium bicarbonate solution, and 50 ml of water in this order. The organic phase thus washed was dried over anhydrous magnesium sulfate and then concentrated in an evaporator to obtain a crude product of a compound J in a solid form. The obtained solid was repetitively recrystallized (hexane/methanol) to obtain 3.60 g of a compound J (white solid) (HPLC purity: 99.9% (254 nm), yield: 72.1%).
¹H-NMR (270 MHz/CDCl₃):
δ1.30-1.70 (m, 24H), 1.70-1.82 (m, 4H), 7.46 (d, 2H), 7.54 (d, 2H), 7.58 (s, 2H)

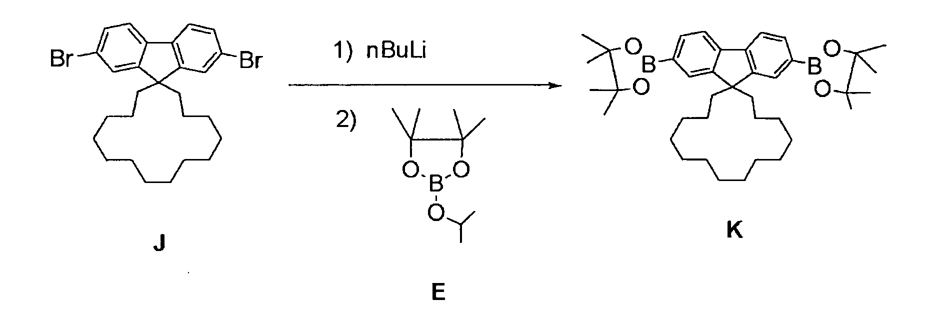

A 100-mL three-neck flask was charged with 3.60 g (6.94 mmol) of the compound J and 50 mL of anhydrous tetrahydrofuran in a nitrogen atmosphere, and the mixture was cooled to -70°C with stirring. 9.6 mL (15.3 mmol) of a 1.59 M solution of n-butyllithium in hexane was added dropwise thereto over 30 minutes, and the mixture was further stirred at -70°C for 1 hour. 3.87 g (20.8 mmol) of the compound E was added dropwise thereto over 30 minutes, and then, the mixture was heated to room temperature and stirred overnight at this temperature. Then, to the obtained solution, 1 mL of a 1 N aqueous hydrochloric acid solution was added, and the mixture was stirred. Then, the obtained reaction solution was added dropwise to 50 mL of water. The solution thus obtained was subjected to extraction with 50 mL of ethyl acetate. Subsequently, the obtained organic phase was dried over anhydrous sodium sulfate and then concentrated in an evaporator to obtain a crude crystal. This crystal was repetitively recrystallized (hexane/methanol) to obtain 2.14 g of a compound K in a boric acid ester form (HPLC purity: 99.8% (254 nm), yield: 50.3%).
¹H-NMR (270 MHz/CDCl₃):
δ1.38 (s, 24M, 1.30-1.62 (m, 24H), 1.70-1.82 (m, 4H), 7.75 (d, 2H), 7.82 (d, 2H), 7.89 (s, 2H)

### <Synthesis Example 7> (Synthesis of polymer compound 3)

A three-neck flask was charged with 0.367 g (0.599 mmol) of the compound K, 0.206 g (0.630 mmol) of 5,5'-dibromo-2,2'-bithiophene, 0.4 mg of dichlorobis(triphenylphosphine)palladium(II), and 0.1 g of methyltrioctylammonium chloride (trade name: Aliquat 336, manufactured by Sigma-Aldrich Inc., CH₃N[(CH₂)₇CH₃]₃Cl, density: 0.884 g/ml (25°C)) in a nitrogen atmosphere. 19 ml of toluene bubbled with nitrogen in advance for 30 minutes was added thereto. The obtained solution was heated to 105°C, and 2 ml of a 2 mol/l aqueous sodium carbonate solution was added dropwise thereto. After the completion of the dropwise addition, the obtained solution was heated to reflux for 3 hours. To the obtained solution, 0.01 g of phenylboronic acid was added, and the mixture was further heated to reflux for 5 hours. 0.1 g of sodium N,N-diethyldithiocarbamate trihydrate and 2 ml of ion-exchanged water were added thereto, and the mixture was stirred at 90°C for 3 hours. After cooling of the obtained solution to room temperature, the aqueous phase was removed, and the organic phase was washed twice with 30 ml of ion-exchanged water at 60°C, twice with 2% by weight of an aqueous acetic acid solution, and twice with ion-exchanged water at 60°C. The obtained organic phase was concentrated in an evaporator. The obtained residue was purified with a silica gel-alumina column, and the purified product was precipitated in methanol to obtain 0.05 g of a polymer compound 3 represented by the following formula: 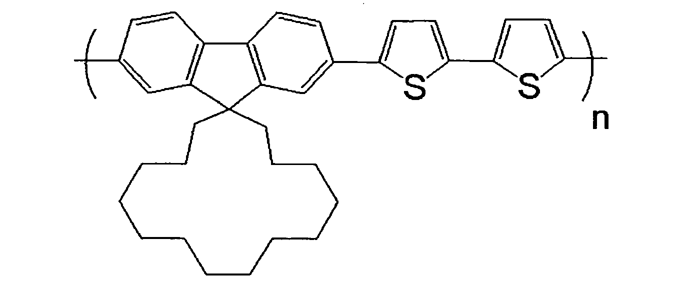 wherein n represents the number of repeating units.
The polymer compound 3 had a number-average molecular weight Mn of 2.5×10³ based on polystyrene standards and a weight-average molecular weight Mw of 4.9×10³ based on polystyrene standards.

### <Synthesis Example 8> (Synthesis of polymer compound 4)

A reaction container was charged with 9.98 g of a compound L (synthesized according to a method described in Japanese Patent Laid-Open No. 2006-169502) represented by the following formula: 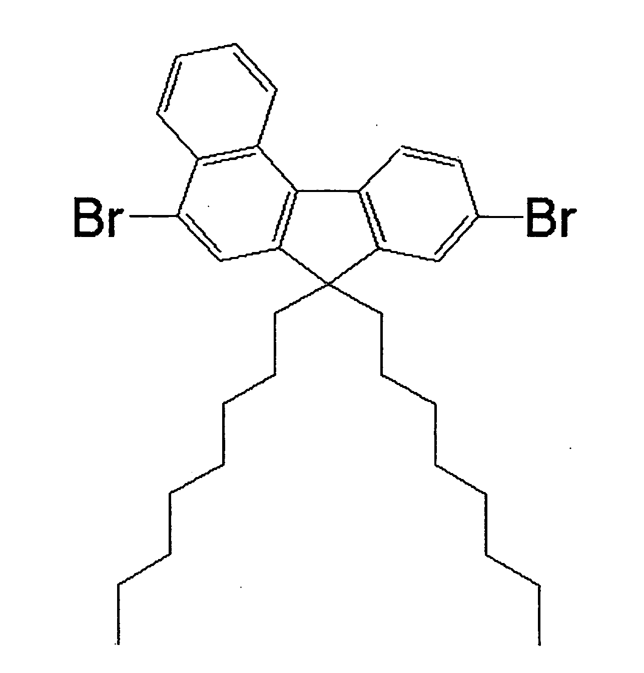 and 7.03 g of 2,2'-bipyridyl, and then, the air within the reaction system was replaced by a nitrogen gas. 1200 mL of tetrahydrofuran (dehydrated solvent) degassed by bubbling with an argon gas in advance was added thereto. Next, to the obtained solution, 12.36 g of bis(1,5-cyclooctadiene)nickel(0) was added, and the mixture was stirred at room temperature for 10 minutes, followed by reaction at 60°C for 3 hours. In this context, the reaction was performed in a nitrogen gas atmosphere.

After the reaction, this reaction solution was cooled. Then, to this solution, a mixed solution of 86 ml of 25% by weight of ammonia water/770 ml of methanol/770 ml of ion-exchanged water was poured, and the mixture was stirred for approximately 1 hour. Next, the resultant precipitate was collected by filtration. This precipitate was dried under reduced pressure and then dissolved in toluene. Undissolved matter was removed from the obtained toluene solution by filtration. The toluene solution thus obtained was applied to a column packed with alumina. Next, the obtained toluene solution was washed with a 1 N aqueous hydrochloric acid solution and left standing. After separation into aqueous and toluene phases, the toluene solution was collected. Next, this toluene solution was washed with approximately 3% by weight of ammonia water and left standing. After separation into aqueous and toluene phases, the toluene solution was collected. Next, this toluene solution was washed with ion-exchanged water and left standing. After separation into aqueous and toluene phases, the toluene solution was collected. Next, this toluene solution was poured to methanol to form a precipitate again.

Next, the formed precipitate was collected and washed with methanol. Then, the obtained precipitate was dried under reduced pressure to obtain 9.94 g of a polymer compound 4 represented by the following formula: 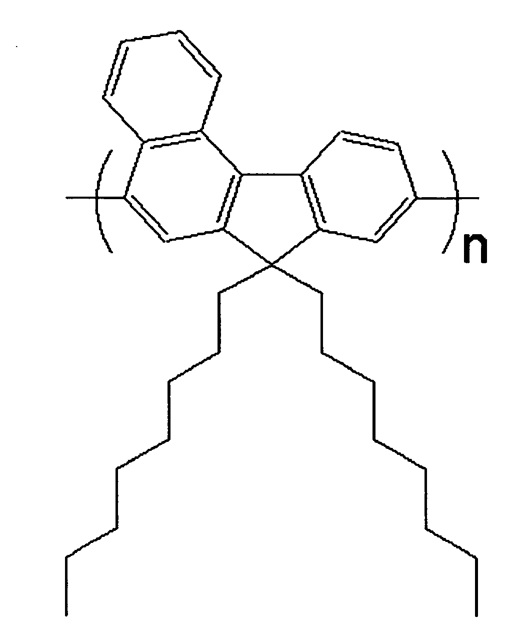 wherein n represents the number of repeating units.
The polymer compound 4 had a number-average molecular weight Mn of 9.8×10⁴ based on polystyrene standards and a weight-average molecular weight Mw of 4.3×10⁵ based on polystyrene standards.

### <Synthesis Example 9> (Synthesis of polymer compound 5)

A 1-L three-neck flask after replacement by nitrogen was charged with 18.55 g (34.98 mmol) of a compound M represented by the following formula: 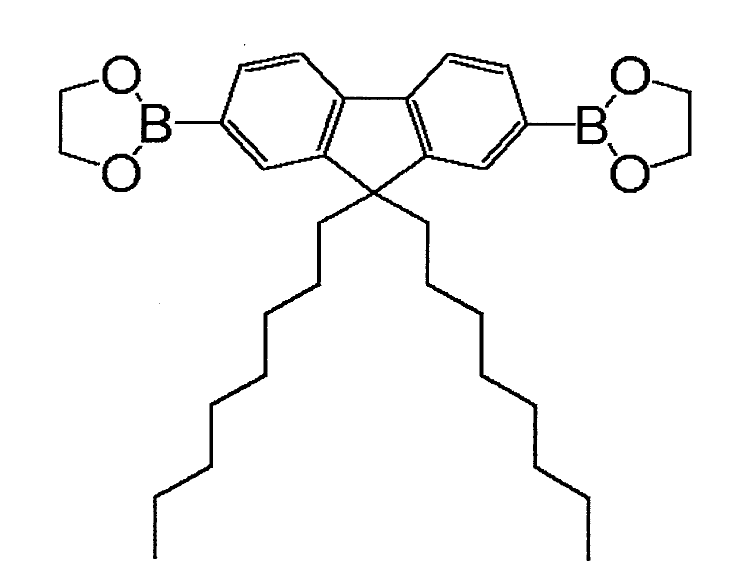 , 11.72 g (36.17 mmol) of 5,5'-dibromo-2,2'-bithiophene, 4.00 g of methyltrioctylammonium chloride (trade name: Aliquat 336, manufactured by Sigma-Aldrich Inc., CH₃N[(CH₂)₇CH₃]₃Cl, density: 0.884 g/ml (25°C)), 0.023 g of Pd(PPh₃)₂Cl₂, and 300 ml of toluene, and the mixture was heated to 55°C and stirred. 60 ml of a 2 mol/l aqueous sodium carbonate solution was added dropwise thereto. After the completion of the dropwise addition, the obtained solution was heated to 95°C, followed by reaction for 24 hours. To the obtained solution, 2.0 g of phenylboronic acid, 40 ml of tetrahydrofuran, and 0.023 g of Pd(PPh₃)₂Cl₂ were added, followed by further reaction for 24 hours. The obtained solution was diluted with 400 ml of toluene, and the organic phase was extracted and then washed three times with 600 ml of hot water. To the obtained solution, 300 ml of 7.5% by weight of an aqueous sodium diethyldithiocarbamate trihydrate solution was added, and the mixture was stirred overnight at 80°C. The mixture was left standing. The aqueous phase was removed, and then, the organic phase was washed with 600 ml of 2% by weight of acetic acid and subsequently twice with 600 ml of hot water. To the obtained solution, 500 ml of toluene was added, and the mixture was poured in two portions to 3 L of methanol for reprecipitation. The obtained solution was subjected to filtration, and the collected polymer was washed with 1 L of methanol and vacuum-dried overnight at 60°C. The obtained polymer was dissolved in 2 L of hot toluene, and the solution was applied to a column using a celite, a silica gel, and basic alumina. The column was washed with 800 ml of hot toluene, and the obtained solution was concentrated to 1300 ml. The solution was poured in two portions to 3 L of methanol to reprecipitate a polymer. The obtained precipitate was filtered to collect the polymer. This polymer was washed with methanol, acetone, and methanol (500 ml each) in this order and vacuum-dried at 60°C to obtain a polymer compound 5 represented by the following formula: 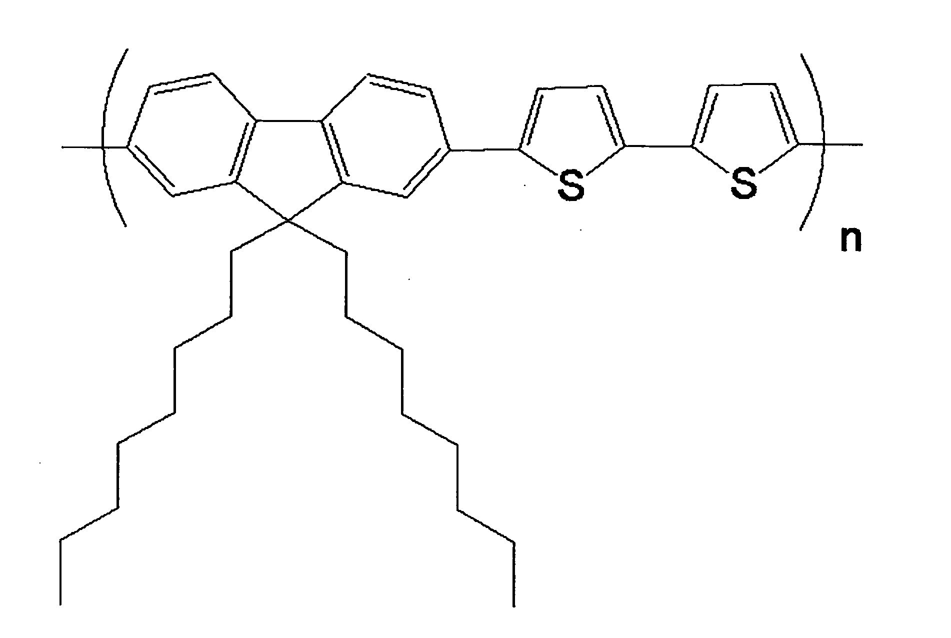 wherein n represents the number of repeating units.
The polymer compound 5 had a number-average molecular weight Mn of 2.2×10⁴ based on polystyrene standards and a weight-average molecular weight Mw of 4.4×10⁴ based on polystyrene standards.

### <Example 1>

### (Preparation and evaluation of organic thin-film solar cell)

PCBM (phenyl C61-butyric acid methyl ester, manufactured by Frontier Carbon Corp., trade name: E100) as an electron-accepting compound and the polymer compound 1 as an electron-donating compound were dissolved at a 3:1 weight ratio in o-dichlorobenzene. The obtained solution was subjected to filtration through a 1.0-µm Teflon (registered trademark) filter to prepare a coating solution.

A glass substrate coated with an ITO film at a thickness of 150 nm by a sputtering method was surface-treated by ozone-UV treatment. Next, the coating solution was applied thereto by spin coating to obtain an active layer (film thickness: 80 nm) of an organic thin-film solar cell. Then, lithium fluoride at a thickness of 4 nm and subsequently aluminum at a thickness of 100 nm were deposited thereon using a vacuum deposition machine to prepare an organic thin-film solar cell. The degree of vacuum in all the deposition procedures was 1 to 9×10⁻³ Pa. The organic thin-film solar cell thus obtained was a 2 mmx2 mm square in shape. The conversion efficiency of the obtained organic thin-film solar cell was measured using a solar simulator (manufactured by Bunkoh-Keiki Co., Ltd., trade name: OTENTO-SUN II: AM1.5G filter, irradiance: 100 mW/cm²). The obtained results are shown in Table 1.

### <Examples 2 and 3 and Comparative Examples 1 to 3>

Organic thin-film solar cells were prepared and evaluated in the same way as in Example 1 except that the weight ratio of the polymer compound 1 as an electron-donating compound to PCBM in Example 1 was changed to the weight ratio of the polymer compound to PCBM shown in the columns of Examples 2 and 3 and Comparative Examples 1 to 3 in Table 1. The obtained results are shown in Table 1.

**Table 1**

| | Polymer compound/ PCBM (weight ratio) | Conversion efficiency (%) |
|---|---|---|
| Example 1 | Polymer compound 1/PCBM = 1/3 | 1.06 |
| Example 2 | Polymer compound 3/PCBM = 1/3 | 2.04 |
| Example 3 | Polymer compound 1/PCBM = 1/1 | 0.55 |
| Comparative Example 1 | Polymer compound 2/PCBM = 1/1 | 0.005 |
| Comparative Example 2 | polymer compound 4/PCBM = 1/1 | 0.002 |
| Comparative Example 3 | Polymer compound 5/PCBM = 1/3 | 0.43 |

### Industrial Applicability

A polymer of the present invention can impart excellent photoelectric conversion efficiency when used in the production of a photoelectric converter. Thus, the polymer of the present invention is useful for the production of an organic photoelectric converter or the like.

## Claims

1. A polymer comprising a repeating unit comprising
a structure represented by the following formula (1a) and/or a structure represented by the following formula (1b), and
a structure represented by the following formula (2): 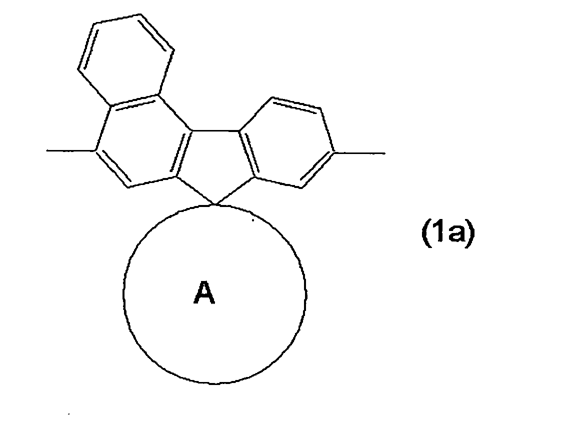 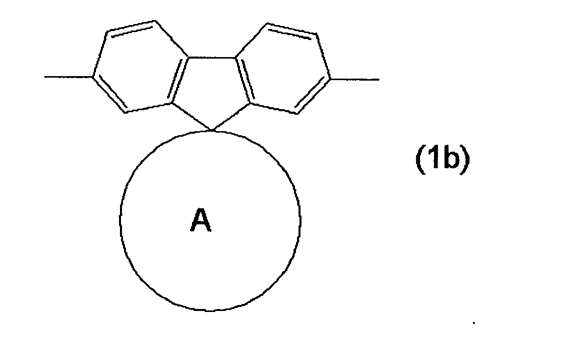 wherein the A ring represents a 6- or more membered monocyclic alicyclic hydrocarbon, and the alicyclic hydrocarbon may be substituted by an alkyl group having 1 to 20 carbon atoms, and 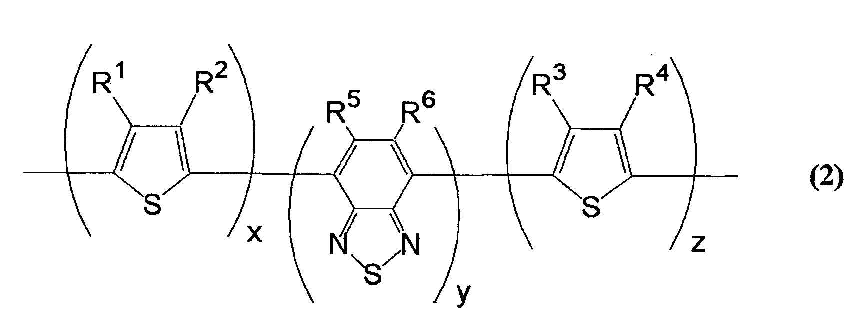 wherein R¹, R², R³, R⁴, R⁵, and R⁶ each independently represent a hydrogen atom, an alkyl group having 1 to 20 carbon atoms, an alkoxy group having 1 to 20 carbon atoms, or an aryl group having 6 to 60 carbon atoms; x is 1 or 2; y is 0 or 1; z is 0, 1, or 2; when a plurality of R¹, R², R³, R⁴, R⁵ or R⁶ are present, they may be the same or different; some or all of the hydrogen atoms of the alkyl group and the alkoxy group each may be substituted by a fluorine atom; and the aryl group may have a substituent.

2. The polymer according to claim 1, wherein the repeating unit is represented by the following formula (3a) or (3b): 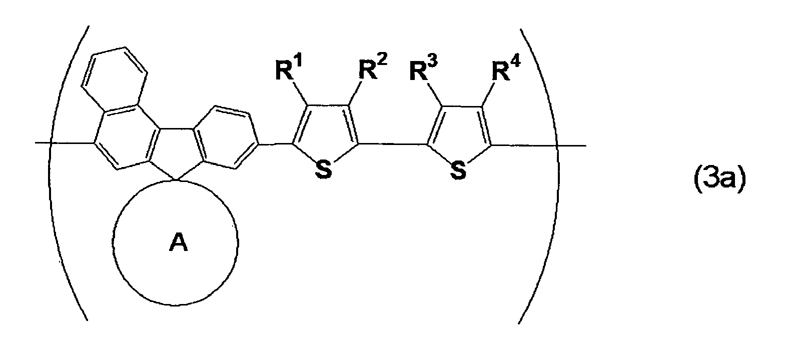 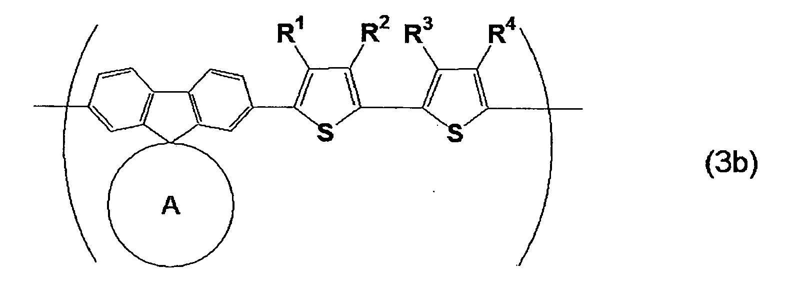 wherein the A ring, R¹, R², R³, and R⁴ are as defined above.

3. The polymer according to claim 1 or 2, wherein the A ring contains 7 or more carbon atoms.

4. The polymer according to any one of claims 1 to 3, wherein the polymer is used for an organic photoelectric converter.

5. An organic photoelectric converter comprising: a pair of electrodes; a first organic layer containing an electron-accepting compound, the first organic layer being disposed between the electrodes; and a second organic layer containing an electron-donating compound, the second organic layer being disposed adjacent to the first organic layer, wherein the electron-donating compound or the electron-accepting compound is a polymer according to any one of claims 1 to 4.

6. An organic photoelectric converter comprising: a pair of electrodes; and at least one organic layer containing an electron-accepting compound and an electron-donating compound, the organic layer being disposed between the electrodes, wherein the electron-donating compound or the electron-accepting compound is a polymer according to any one of claims 1 to 4.

7. An organic photoelectric converter comprising: a pair of electrodes; and at least one organic layer containing an electron-accepting compound and an electron-donating compound, the organic layer being disposed between the electrodes, wherein the electron-donating compound is a polymer according to any one of claims 1 to 4, and the electron-accepting compound is a fullerene derivative.

8. The organic photoelectric converter according to claim 7, wherein the organic layer containing an electron-accepting compound and an electron-donating compound contains the electron-accepting compound in an amount of 10 to 1000 parts by weight per 100 parts by weight of the electron-donating compound.
